# EUROPEAN PATENT APPLICATION

(11) **EP 4 765 124 A1**
(43) Date of publication of application: **24.06.2026**
(21) Application number: 25224186.4
(22) Date of filing: 17.12.2025
(51) Int. Cl.: G11C 8/14, H10B 12/00, H10D 30/67, H10D 62/10

(54) **SEMICONDUCTOR DEVICE AND METHOD FOR FABRICATING THE SAME**

(30) Priority: 17.12.2024 KR 20240188016
(71) Applicant: SK hynix Inc., Bubal-eub Icheon-si Gyeonggi-do 17336 (KR)
(72) Inventor: KWAK, Jun Ha, 17336 Icheon-si, Gyeonggi-do (KR); CHOI, Kang Sik, 17336 Icheon-si, Gyeonggi-do (KR); SEO, Jung Won, 17336 Icheon-si, Gyeonggi-do (KR); LEE, Sang Soo, 17336 Icheon-si, Gyeonggi-do (KR)
(74) Representative: Isarpatent

(57) **Abstract**

A semiconductor device including high-integrated memory cells and a method for fabricating the semiconductor device are provided. The semiconductor device includes a first memory cell array including a vertical arrangement of first memory cells, a second memory cell array vertically disposed over the first memory cell array, and including a vertical arrangement of second memory cells, and a dummy memory cell array vertically disposed between the first memory cell array and the second memory cell array, and including a vertical arrangement of dummy memory cells. The first memory cells, the second memory cells and the dummy memory cells have the same structure.

## Description

### BACKGROUND

### 1. Field

Various embodiments of the present disclosure relate to a semiconductor device, and more particularly, to a semiconductor device including three-dimensional (3D) memory cells, and a method for fabricating the semiconductor device.

### 2. Description of the Related Art

Recently, in order to cope with the growing demand for larger capacity and greater miniaturization of memory devices, three-dimensional (3D) memory device in which a plurality of memory cells are stacked has been proposed.

### SUMMARY

Embodiments of the present disclosure are directed to a semiconductor device including high-integrated memory cells, and a method for fabricating the semiconductor device.

In accordance with an embodiment of the present disclosure, a method for fabricating a semiconductor device may include: forming a first vertical stack in which a plurality of first semiconductor layers are vertically stacked over a substrate; etching the first semiconductor layers of the first vertical stack and forming first contact holes; forming dummy semiconductor layers from an uppermost first semiconductor layer of the first vertical stack; forming second semiconductor layers on the dummy semiconductor layers to form a second vertical stack; etching the second semiconductor layers of the second vertical stack and forming second contact holes; and replacing the first and second semiconductor layers with pads.

In accordance with an embodiment of the present disclosure, a method for fabricating a semiconductor device may include: forming a first vertical stack in which first pad sheets are vertically stacked over a substrate; etching the first pad sheets of the first vertical stack and forming first contact holes; forming first sacrificial plugs that fill the first contact holes; forming a dummy stack including dummy pad sheets on the first sacrificial plugs and the first vertical stack; forming a second vertical stack in which second pad sheets are vertically stacked on the dummy stack; etching the second pad sheets of the second vertical stack and forming second contact holes; forming second sacrificial plugs that fill the second contact holes; removing the second pad sheets and the first pad sheets and forming pad-shaped recesses; forming pads that fill the pad-shaped recesses; and replacing the first and second sacrificial plugs with contact plugs.

In accordance with an embodiment of the present disclosure, a method for fabricating a semiconductor device may include: forming, over a substrate, a first vertical arrangement of first nano sheets and a first vertical arrangement of first pad sheets, which horizontally extend from the first nano sheets in the first vertical arrangement; etching the first pad sheets and forming first contact holes; forming first sacrificial plugs that fill the first contact holes; forming a dummy stack including dummy pad sheets on the first sacrificial plugs, the first vertical arrangement of the first nano sheets and the first vertical arrangement of the first pad sheets; forming, on the dummy stack, a second vertical arrangement of second nano sheets and a second vertical arrangement of second pad sheets, which horizontally extend from the second nano sheets in the second vertical arrangement; etching the second pad sheets and forming second contact holes; forming second sacrificial plugs that fill the second contact holes; forming a vertical arrangement of horizontal conductive lines each surrounding the first and second nano sheets; removing the second pad sheets and the first pad sheets and forming pad-shaped recesses; forming pads that fill the pad-shaped recesses and are each coupled to the horizontal conductive lines; and replacing the first and second sacrificial plugs with contact plugs.

In accordance with an embodiment of the present disclosure, a semiconductor device may include: a first memory cell array including a vertical arrangement of first memory cells; a second memory cell array vertically disposed over the first memory cell array, and including a vertical arrangement of second memory cells; and a dummy memory cell array vertically disposed between the first memory cell array and the second memory cell array, and including a vertical arrangement of dummy memory cells between the first memory cell array and the second memory cell array. The first memory cells, the second memory cells and the dummy memory cells have the same structure.

In accordance with an embodiment of the present disclosure, a semiconductor device may include a first pad stack including a vertical arrangement of first pads; a second pad stack vertically disposed over the first pad stack, and including a vertical arrangement of second pads;
a dummy pad stack vertically disposed between the first pad stack and the second pad stack, and including a vertical arrangement of dummy pads; and a plurality of contact plugs penetrating the second pad stack, the dummy pad stack, and the first pad stack.

### BRIEF DESCRIPTION OF THE DRAWINGS

FIG. 1 is a schematic perspective view illustrating a memory cell in accordance with an embodiment of the present disclosure.
FIG. 2 is a schematic cross-sectional view of the memory cell illustrated in FIG. 1.
FIG. 3 is a schematic perspective view illustrating a memory cell array in accordance with an embodiment of the present disclosure.
FIG. 4 is a schematic plan view illustrating a semiconductor device in accordance with an embodiment of the present disclosure.
FIG. 5A and 5B is a cross-sectional view of the semiconductor device taken along line A-A' illustrated in FIG. 4.
FIG. 6 is a cross-sectional view of the semiconductor device taken along line B-B' illustrated in FIG. 4.
FIGS. 7 to 29B illustrate various views of a semiconductor device formed utilizing a method for fabricating the semiconductor device in accordance with an embodiment of the present disclosure.

### DETAILED DESCRIPTION

Various embodiments of the present disclosure described herein may be described with reference to cross-sectional views, plan views and block diagrams, which are ideal schematic views of a semiconductor device. It is noted that the structures of the drawings may be modified by fabricating techniques and/or tolerances. The embodiments of the present disclosure are not limited to the described embodiments and the specific structures illustrated in the drawings, but may include other embodiments, or modifications of the described embodiments including any changes in the structures that may be produced according to requirements of the fabricating process. Accordingly, the regions illustrated in the drawings have schematic attributes, and the shapes of the regions illustrated in the drawings are intended to illustrate specific structures of regions of the elements, and are not intended to limit the scope of the disclosure.

The following embodiment relates to three-dimensional memory cells, in which memory cells are vertically stacked to increase memory cell density and reduce parasitic capacitance.

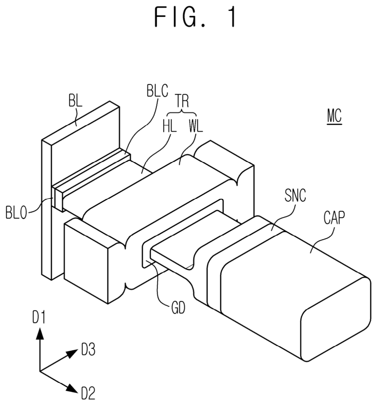

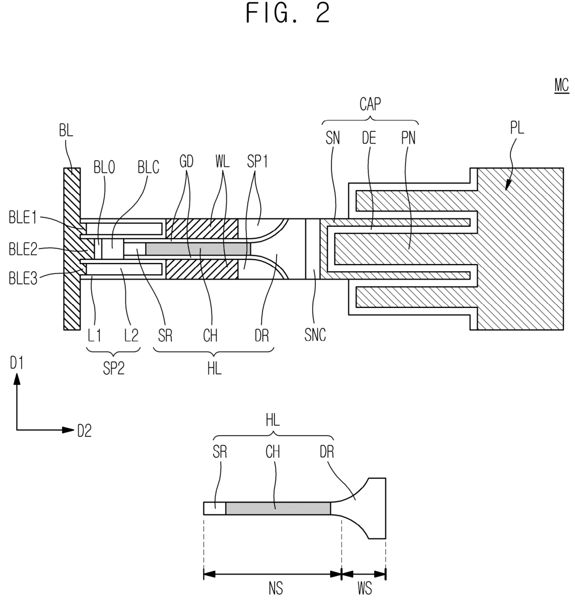

FIG. 1 is a schematic perspective view illustrating a memory cell MC in accordance with an embodiment of the present disclosure. FIG. 2 is a schematic cross-sectional view of the memory cell MC illustrated in FIG. 1.

Referring to FIGS. 1 and 2, the memory cell MC may include a first conductive line BL, a switching element TR, and a data storage element CAP.

The first conductive line BL may be vertically oriented in a first direction D1. The first conductive line BL may include a bit line. The first conductive line BL may be referred to as a "vertical conductive line", a "vertically-oriented bit line", a "vertically-extending bit line", or a "pillar-shaped bit line". The first conductive line BL may include a conductive material. The first conductive line BL may include a silicon-based material, a metal-based material, or a combination thereof. The first conductive line BL may include polysilicon, metal, metal nitride, metal silicide, or a combination thereof. The first conductive line BL may include polysilicon, titanium nitride, tungsten, or a combination thereof. For example, the first conductive line BL may include a titanium nitride/tungsten (TiN/W) stack in which titanium nitride and tungsten are sequentially stacked.

The switching element TR has a function of controlling voltage or current supply to the data storage element CAP during a data write operation and a data read operation performed on the data storage element CAP. The switching element TR may include a nano sheet HL, a nano sheet dielectric layer GD, and a second conductive line WL. The second conductive line WL may include a horizontal conductive line or a horizontal word line, and the nano sheet HL may include an active layer. The switching element TR may include a transistor, and in this case, the second conductive line WL may serve as a gate electrode. The switching element TR may also be referred to as a "nano sheet transistor", a "cell transistor", an "access element" or a "selection element". The second conductive line WL may be referred to as a "horizontal gate electrode" or a "horizontal word line".

The nano sheet HL may extend in a second direction D2 that intersects with the first direction D1. The second conductive line WL may extend in a third direction D3 that intersects with the first direction D1 and the second direction D2. The first direction D1 may be a vertical direction, the second direction D2 may be a first horizontal direction, and the third direction D3 may be a second horizontal direction. The nano sheet HL may extend in the first horizontal direction, i.e., the second direction D2, and the second conductive line WL may extend in the second horizontal direction, i.e., the third direction D3. The nano sheet HL may be referred to as a "horizontal layer".

The nano sheet HL may include a channel CH, a first doped region SR between the channel CH and the first conductive line BL, and a second doped region DR between the channel CH and the data storage element CAP. The first doped region SR may be electrically coupled to the first conductive line BL, and the second doped region DR may be electrically coupled to the data storage element CAP. A height of the second doped region DR in the first direction D1 may be greater than heights of the first doped region SR and the channel CH in the first direction D1. A length of the second doped region DR in the second direction D2 may be less than a length of the channel CH in the second direction D2. The lengths of the first doped region SR, the channel CH and the second doped region DR in the third direction D3 may be equal to one another.

The nano sheet HL may include a first sheet region NS and a second sheet region WS that are horizontally disposed in the second direction D2. The second sheet region WS may extend from the first sheet region NS. The second sheet region WS may have a thickness that gradually increases in the second direction D2 from the first sheet region NS toward the data storage element CAP between the first sheet region NS and the data storage element CAP. An average vertical height or thickness of the second sheet region WS in the first direction D1 may be greater than an average vertical height or thickness of the first sheet region NS. Hereinafter, the first sheet region NS is referred to as a "narrow sheet", and the second sheet region WS is referred to as a "wide sheet".

The narrow sheet NS may have a flat plate shape. The wide sheet WS may have a fan-like (for example, a tapering) shape. The wide sheet WS may have a thickness that gradually increases in the second direction D2. The narrow sheet NS may be referred to as a "flat plate-shaped sheet", and the wide sheet WS may be referred to as a "fan-like shaped sheet". A boundary portion between the narrow sheet NS and the wide sheet WS may have a curvature.

The first doped region SR and the channel CH may be disposed in the narrow sheet NS, and the second doped region DR may be disposed in the wide sheet WS. The channel CH formed in the narrow sheet NS may be referred to as a "narrow channel" or a "flat channel". One side of the wide sheet WS and one side of the second doped region DR, which contact the data storage element CAP, may each have a flat side shape.

In some embodiments, a portion of the second doped region DR may extend into (or be disposed in) the narrow sheet NS. The second doped region DR may include a thick portion disposed in the wide sheet WS and a thin portion disposed in the narrow sheet NS..

A horizontal length of the wide sheet WS in the second direction D2 may be less than a horizontal length of the narrow sheet NS. The narrow sheet NS may be referred to as a "long sheet", and the wide sheet WS may be referred to as a "short sheet".

The nano sheet HL may include a semiconductive material. For example, the nano sheet HL may include polysilicon, monocrystalline silicon, germanium, or silicon-germanium. In some embodiments, the nano sheet HL may include an oxide semiconductor material. For example, the oxide semiconductor material may include indium gallium zinc oxide (IGZO), InSnZnO, ZnSnO, or a combination thereof. In some embodiments, the nano sheet HL may include conductive metal oxide. In some embodiments, the nano sheet HL may include a two-dimensional material, for example, MoS₂, WS₂, or MoSe₂.

When the nano sheet HL is formed of the oxide semiconductor material, the channel CH may also be formed of the oxide semiconductor material, and the first and second doped regions SR and DR may be omitted. The nano sheet HL may also be referred to as an "active layer" or a "thin body".

The first doped region SR and the second doped region DR may be doped with an impurity of the same conductivity type. Each of the first doped region SR and the second doped region DR may be doped with an N-type conductive impurity or a P-type conductive impurity. The first doped region SR and the second doped region DR may each include at least one impurity selected from among arsenic (As), phosphorus (P), boron (B), indium (In), and combinations thereof. The first doped region SR may be electrically coupled to the first conductive line BL, and the second doped region DR may be electrically coupled to the data storage element CAP. The first and second doped regions SR and DR may be referred to as "first and second source/drain regions".

The nano sheet HL may be horizontally oriented in the second direction D2 from the first conductive line BL.

The second conductive line WL may have a gate-all-around (GAA) structure. For example, the second conductive line WL may surround the nano sheet HL and extend in the third direction D3. The nano sheet dielectric layer GD may be formed between the nano sheet HL and the second conductive line WL. The nano sheet dielectric layer GD may surround a portion of the nano sheet HL, for example, the channel CH of the nano sheet HL. The second conductive line WL may surround the nano sheet HL on the nano sheet dielectric layer GD. The second conductive line WL may include a combination of a surrounding body and a surrounding merged portion (for example, a portion merged with the surrounding body). The surrounding body may surround the nano sheet HL on the nano sheet dielectric layer GD. The surrounding merged portion may be disposed at both ends of the surrounding body (for example, as shown in FIG. 1). The surrounding body and the surrounding merged portion may have an integral structure and be formed of the same material. In some embodiments, the surrounding body and the surrounding merged portion may be referred to as an "around body" and an "around merged portion", respectively. The switching element TR may include a gate-all-around (GAA) transistor.

The second conductive line WL may include a metal-based material, a semiconductive material, or a combination thereof. The second conductive line WL may include molybdenum, molybdenum nitride, ruthenium, titanium nitride, tungsten, polysilicon, or a combination thereof. For example, the second conductive line WL may include a TiN/W stack in which titanium nitride (TiN) and tungsten (W) are sequentially stacked. The second conductive line WL may include an N-type work function material or a P-type work function material. The N-type work function material may have a low work function of approximately 4.5 eV or less, and the P-type work function material may have a high work function of approximately 4.5 eV or greater. The second conductive line WL may include a stack of a low work function material and a high work function material.

The nano sheet dielectric layer GD may be disposed between the nano sheet HL and the second conductive line WL. The nano sheet dielectric layer GD may be referred to as a "gate dielectric layer" or a "channel-side dielectric layer". The nano sheet dielectric layer GD may include silicon oxide, silicon nitride, metal oxide, metal oxide nitride, metal silicate, a high-k material, a ferroelectric material, an anti-ferroelectric material, or a combination thereof. The nano sheet dielectric layer GD may include SiO₂, Si₃N₄, HfO₂, Al₂O₃, ZrO₂, AlON, HfON, HfSiO, HfSiON, HfZrO, or a combination thereof. The nano sheet dielectric layer GD may be formed by combining deposition of a nano sheet dielectric material and thermal oxidation of the nano sheet HL. In some embodiments, the nano sheet dielectric layer GD may be deposited on the nano sheet HL or formed by the thermal oxidation of the nano sheet HL.

The data storage element CAP may include a memory element such as a capacitor. The data storage element CAP may be horizontally disposed in the second direction D2 from the switching element TR. The data storage element CAP may include a first electrode SN, a second electrode PN, and a dielectric layer DE between the first electrode SN and the second electrode PN. The first electrode SN may horizontally extend in the second direction D2 from the nano sheet HL. The first electrode SN, the dielectric layer DE and the second electrode PN may be horizontally disposed in the second direction D2. The first electrode SN may include an inner space and a plurality of outer surfaces, and the inner space of the first electrode SN may include a plurality of inner surfaces. The outer surfaces of the first electrode SN may include a vertical outer surface and a plurality of horizontal outer surfaces. The vertical outer surface of the first electrode SN may vertically extend in the first direction D1, and the horizontal outer surfaces of the first electrode SN may horizontally extend in the second direction D2 or the third direction D3. The inner space of the first electrode SN may be a three-dimensional space. The dielectric layer DE may conformally cover the inner surfaces and outer surfaces of the first electrode SN. The second electrode PN may be disposed in the inner space of the first electrode SN on the dielectric layer DE. Some of the outer surfaces of the first electrode SN may be electrically coupled to the second doped region DR of the nano sheet HL. The second electrode PN of the data storage element CAP may be coupled to a common plate PL. The first electrode SN may be referred to as a "storage node".

The data storage element CAP may have a three-dimensional structure. The first electrode SN may have a three-dimensional structure, for example, a horizontal three-dimensional structure that is oriented in the second direction D2. In an example of the three-dimensional structure, the first electrode SN may have a cylindrical shape. The cylindrical shape of the first electrode SN may include cylindrical inner surfaces and cylindrical outer surfaces. Some of the cylindrical outer surfaces of the first electrode SN may be electrically coupled to the second doped region DR of the nano sheet HL. The dielectric layer DE and the second electrode PN may be disposed on the cylindrical inner surfaces and cylindrical outer surfaces of the first electrode SN. In an embodiment, the first electrode SN may have a semi-cylindrical shape. Specifically, the semi-cylindrical shape may refer to a structure in which the second electrode PN partially covers the outer surfaces of the first electrode SN.

In some embodiments, the first electrode SN may have a pillar shape or a pylinder shape. The pylinder shape may refer to a structure in which a pillar shape and a cylindrical shape are merged.

Each of the first electrode SN and the second electrode PN may include metal, noble metal, metal nitride, conductive metal oxide, conductive noble metal oxide, metal carbide, metal silicide, or a combination thereof. For example, each of the first electrode SN and the second electrode PN may each include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, or a combination thereof. The second electrode PN may also include a combination of a metal-based material and a silicon-based material. For example, the second electrode PN may be a titanium nitride/silicon germanium/tungsten nitride (TiN/SiGe/WN) stack. In the titanium nitride/silicon germanium/tungsten nitride (TiN/SiGe/WN) stack, silicon germanium may be a gap-fill material that fills the inside of the first electrode SN, titanium nitride (TiN) may serve as the second electrode PN of the data storage element CAP, and tungsten nitride may be a low-resistance material. In some embodiments, the second electrode PN may include a titanium nitride/tungsten/polysilicon (TiN/W/Poly-Si) stack.

The dielectric layer DE may be referred to as a "capacitor dielectric layer" or a "memory layer". The dielectric layer DE may include silicon oxide, silicon nitride, a high-k material, a perovskite material, or a combination thereof. The high-k material may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅), or strontium titanium oxide (SrTiO₃). In some embodiments, the dielectric layer DE may be formed of a composite layer including two or more layers of the above-described high-k material.

The dielectric layer DE may be formed of a zirconium (Zr)-based oxide. The dielectric layer DE may have a stack structure containing zirconium oxide (ZrO₂). The dielectric layer DE may include a ZA (ZrO₂/Al₂O₃) stack or a ZAZ (ZrO₂/Al₂O₃/ZrO₂) stack. The ZA stack may have a structure in which aluminum oxide (Al₂O₃) is stacked on zirconium oxide (ZrO₂). The ZAZ stack may have a structure in which zirconium oxide (ZrO₂), aluminum oxide (Al₂O₃) and zirconium oxide (ZrO₂) are sequentially stacked. Each of the ZA stack and the ZAZ stack may be referred to as a "zirconium oxide (ZrO₂)-based layer". In some embodiments, the dielectric layer DE may be formed of hafnium (Hf)-based oxide. The dielectric layer DE may have a stack structure containing hafnium oxide (HfO₂). The dielectric layer DE may include an HA (HfO₂/Al₂O₃) stack or an HAH (HfO₂/Al₂O₃/HfO₂) stack. The HA stack may have a structure in which aluminum oxide (Al₂O₃) is stacked on hafnium oxide (HfO₂). The HAH stack may have a structure in which hafnium oxide (HfO₂), aluminum oxide (Al₂O₃) and hafnium oxide (HfO₂) are sequentially stacked. Each of the HA stack and the HAH stack may be referred to as a "hafnium oxide (HfO₂)-based layer". In the ZA stack, ZAZ stack, HA stack and HAH stack, aluminum oxide (Al₂O₃) may have a greater band gap energy than zirconium oxide (ZrO₂) and hafnium oxide (HfO₂). Aluminum oxide (Al₂O₃) may have a lower dielectric constant than zirconium oxide (ZrO₂) and hafnium oxide (HfO₂). Accordingly, the dielectric layer DE may include a stack of a high-k material and a high band gap material having a greater band gap energy than the high-k material. The dielectric layer DE may include silicon oxide (SiO₂) as a high band gap material other than aluminum oxide (Al₂O₃). Because the dielectric layer DE includes a high band gap material, leakage current may be suppressed. The high band gap material may be thinner than the high-k material. In some embodiments, the dielectric layer DE may include a stack structure in which a high-k material and a high band gap material are alternately stacked. For example, the dielectric layer DE may include a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HAHA (HfO₂/Al₂O₃/HfO₂/Al₂O₃) stack, a HAHAH (HfO₂/Al₂O₃/HfO₂/Al₂O₃/HfO₂) stack, a HZAZH (HfO₂/ZrO₂/Al₂O₃/ZrO₂/HfO₂) stack, a ZHZAZHZ (ZrO₂/HfO₂/ZrO₂/Al₂O₃/ZrO₂/HfO₂/ZrO₂) stack, a HZHZ (HfO₂/ZrO₂/HfO₂/ZrO₂) stack, or an AHZAZHA (Al₂O₃/HfO₂/ZrO₂/Al₂O₃/ZrO₂/HfO₂/Al₂O₃) stack. In the above-described stack structures, aluminum oxide (Al₂O₃) may be thinner than zirconium oxide (ZrO₂) and hafnium oxide (HfO₂).

In some embodiments, the dielectric layer DE may include a high-k material and a high band gap material. The dielectric layer DE may have a laminated structure in which a plurality of high-k materials and a plurality of high band gap materials are stacked or an intermixed structure in which a high-k material and a high band gap material are intermixed.

In some embodiments, the dielectric layer DE may include a ferroelectric material, an anti-ferroelectric material, or a combination thereof. For example, the dielectric layer DE may include HfZrO.

In some embodiments, the dielectric layer DE may include a combination of a high-k material and a ferroelectric material, a combination of a high-k material and an anti-ferroelectric material, or a combination of a high-k material or a ferroelectric material and an anti-ferroelectric material.

In some embodiments, an interface control layer may be further formed between the first electrode SN and the dielectric layer DE to alleviate leakage current. The interface control layer may include titanium oxide (TiO₂), tantalum oxide (Ta₂O₅), niobium oxide (Nb₂O₅), niobium nitride (NbN), or a combination thereof. The interface control layer may also be formed between the second electrode PN and the dielectric layer DE.

The data storage element CAP may include a three-dimensional capacitor. The data storage element CAP may include a Metal-Insulator-Metal (MIM) capacitor. The data storage element CAP may be replaced with another data storage material. For example, the data storage material may be a thyristor, a phase-change material, a Magnetic Tunnel Junction (MTJ), or a variable resistance material.

The memory cell MC may further include a first contact node BLC and a second contact node SNC. The first contact node BLC may be disposed between the first conductive line BL and the nano sheet HL. The first contact node BLC may include a metal-based material or a semiconductive material. For example, the first contact node BLC may include titanium, titanium nitride, tungsten, or a combination thereof. In addition, the first contact node BLC may include doped polysilicon, and the first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped silicon, and the second doped region DR may include an impurity diffused from the second contact node SNC. A height of the first contact node BLC in the first direction D1 may be less than a height of the second contact node SNC in the first direction D1. The height of the first contact node BLC in the first direction D1 may be greater than a height of the channel CH in the first direction D1.

In some embodiments, the second contact node SNC may be selectively grown from the wide sheet WS of the nano sheet HL. The second contact node SNC may be formed by selective epitaxial growth (SEG). For example, the second contact node SNC may be a silicon epitaxial layer formed by the SEG. The second contact node SNC may be a doped silicon epitaxial layer.

In some embodiments, the first contact node BLC may also be selectively grown from the narrow sheet NS of the nano sheet HL. The first contact node BLC may be formed by selective epitaxial growth (SEG). For example, the first contact node BLC may be a silicon epitaxial layer formed by the SEG. The first contact node BLC may be a doped silicon epitaxial layer.

The first contact node BLC may be a narrow sheet-side contact node, and the second contact node SNC may be a wide sheet-side contact node.

The nano sheet HL may include a first edge and a second edge. The first edge may refer to a portion of the first doped region SR electrically coupled to the first conductive line BL, and the second edge may refer to a portion of the second doped region DR electrically coupled to the first electrode SN of the data storage element CAP.

The memory cell MC may further include an ohmic contact layer BLO between the first contact node BLC and the first conductive line BL. The ohmic contact layer BLO may include metal silicide. In some embodiments, the memory cell MC may further include an ohmic contact layer formed between the second contact node SNC and the first electrode SN of the data storage element CAP. The first conductive line BL, the ohmic contact layer BLO, the first contact node BLC and the first doped region SR may be electrically coupled to one another. The second doped region DR, the second contact node SNC and the first electrode SN of the data storage element CAP may be electrically coupled to one another.

The memory cell MC may further include a first spacer SP1 and a second spacer SP2. The first spacer SP1 may be disposed between the second conductive line WL and the second doped region DR. The second spacer SP2 may be disposed between the first conductive line BL and the second conductive line WL. The first and second spacers SP1 and SP2 may surround the nano sheet HL and extend in the third direction D3. That is, the first and second spacers SP1 and SP2 may be disposed on both sidewalls of the second conductive line WL and surround the nano sheet HL.

The first and second spacers SP1 and SP2 may each have a double liner structure or a single liner structure. For example, the first spacer SP1 may have the single liner structure, and the second spacer SP2 may have the double liner structure. The second spacer SP2 may include a stack of a first liner L1 and a second liner L2. The first and second spacers SP1 and SP2 may each include a dielectric material. The first and second spacers SP1 and SP2 may each include silicon oxide, silicon nitride, or a combination thereof. The first liner L1 of the second spacer SP2 may be silicon nitride, whereas the second liner L2 of the second spacer SP2 may be silicon oxide. The second liner L2 may partially fill an inner space of the first liner L1.

The first conductive line BL may include a plurality of horizontal extension portions BLE1, BLE2, and BLE3. The horizontal extension portions BLE1, BLE2, and BLE3 may extend in the second direction D2. The horizontal extension portions may include an inner horizontal extension portion BLE2 and outer horizontal extension portions BLE1 and BLE3. The inner horizontal extension portion BLE2 of the first conductive line BL may extend to be disposed in a gap between the first liners L1 vertically adjacent to each other. Accordingly, the inner horizontal extension portion BLE2 of the first conductive line BL may be electrically coupled to the ohmic contact layer BLO.

The outer horizontal extension portions BLE1 and BLE3 of the first conductive line BL may extend to be disposed in one side of the second spacer SP2. Accordingly, the outer horizontal extension portions BLE1 and BLE3 of the first conductive line BL may contact the second liner L2 of the second spacer SP2. In some embodiments, the outer horizontal extension portions BLE1 and BLE3 of the first conductive line BL may be omitted.

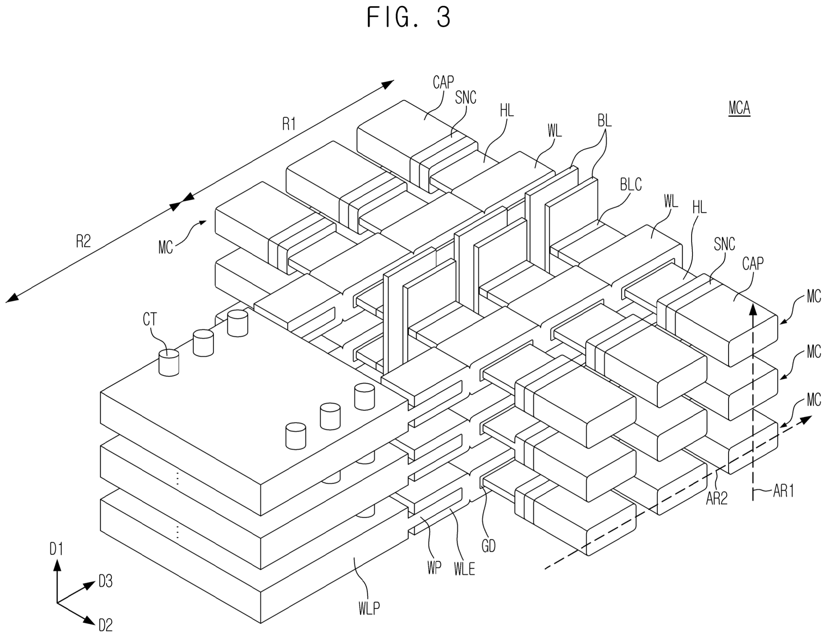

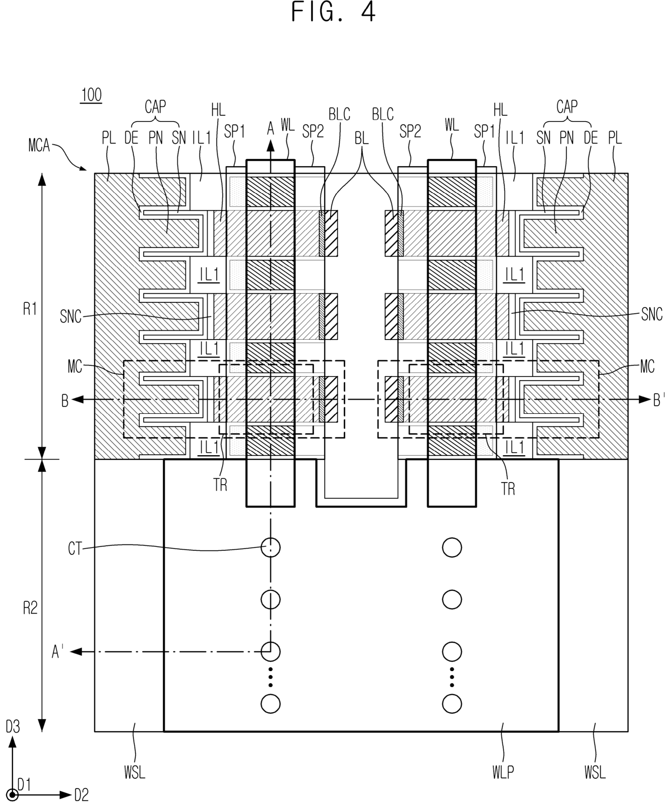

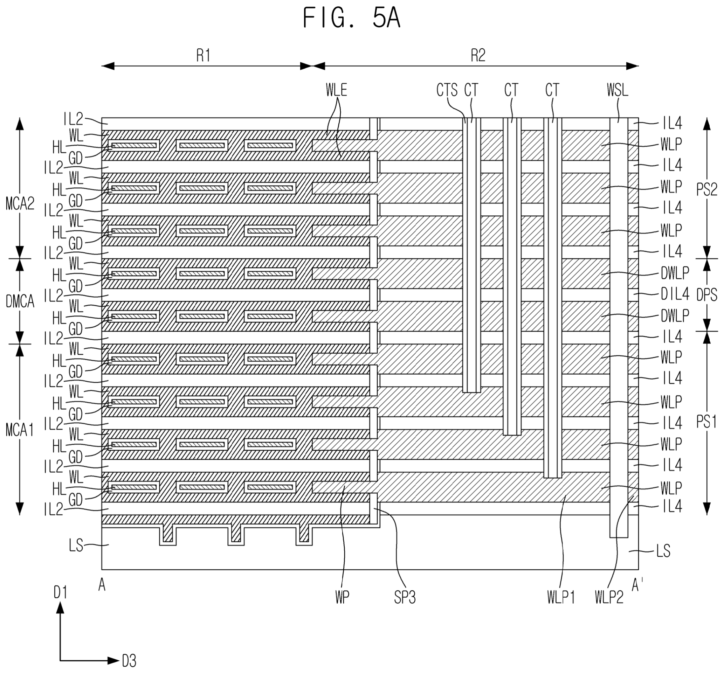

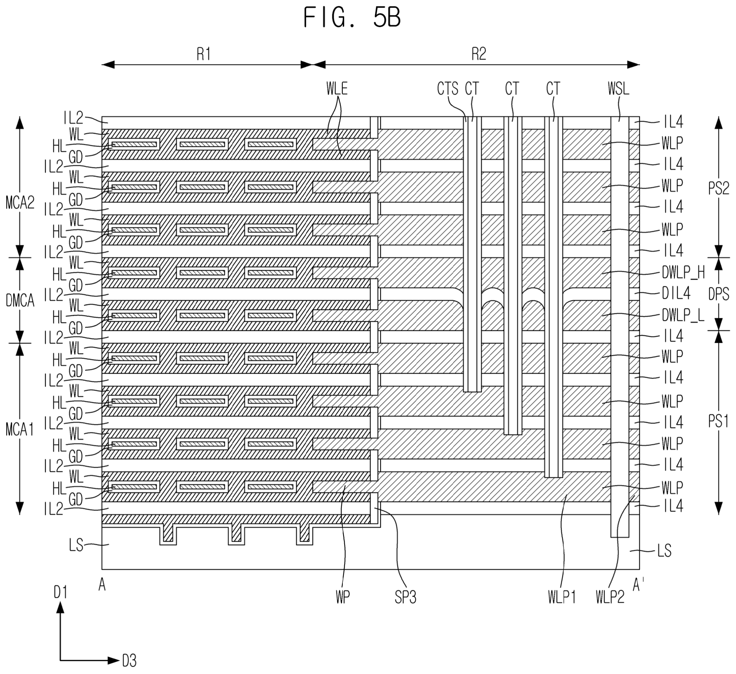

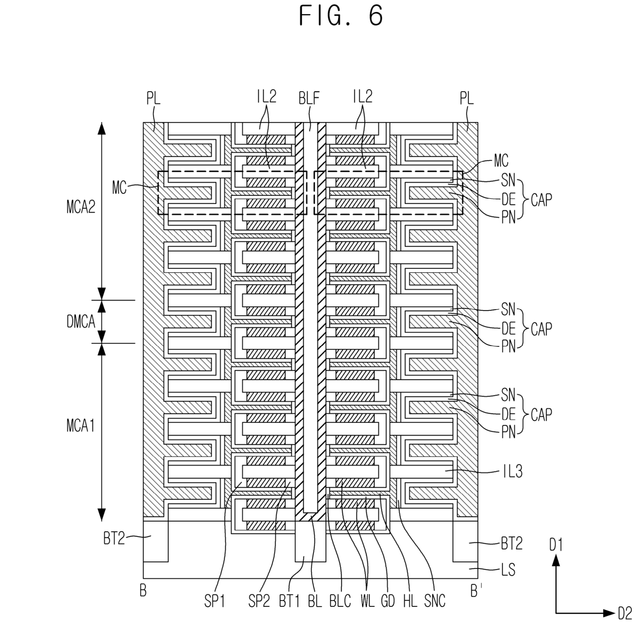

FIG. 3 is a schematic perspective view illustrating a memory cell array MCA in accordance with an embodiment of the present disclosure. FIG. 4 is a schematic plan view illustrating a semiconductor device 100 in accordance with an embodiment of the present disclosure. FIG. 5A and 5B is a cross-sectional view of the semiconductor device 100 taken along line A-A' illustrated in FIG. 4. FIG. 6 is a cross-sectional view of the semiconductor device 100 taken along line B-B' illustrated in FIG. 4.

Referring to FIG. 3, the semiconductor device may include the memory cell array MCA. The memory cell array MCA may include a plurality of memory cells MC vertically stacked in a first direction D1. The memory cell array MCA may include a plurality of memory cells MC horizontally disposed in a second direction D2. The memory cell array MCA may include a plurality of memory cells MC horizontally disposed in a third direction D3.

Each of the memory cells MC may include a first conductive line BL, a switching element TR, and a data storage element CAP. The switching element TR may include a second conductive line WL, a nano sheet dielectric layer GD, and a nano sheet HL. The memory cells MC may further include a first contact node BLC, an ohmic contact layer BLO, and a second contact node SNC. The memory cell MC may be the same as the memory cell MC illustrated in FIGS. 1 and 2.

The memory cell array MCA may include a column array AR1 of the memory cells MC and a row array AR2 of the memory cells MC. The column array AR1 may include the plurality of memory cells MC vertically stacked in the first direction D1. The memory cells MC in the column array AR1 may share the first conductive line BL. The row array AR2 may include the plurality of memory cells MC horizontally disposed in the third direction D3. The memory cells MC in the row array AR2 may share the second conductive line WL. The second conductive line WL of the memory cell array MCA may have a structure in which a plurality of surrounding bodies and a plurality of surrounding merge portions are merged with each other. The surrounding merge portions may be disposed in gaps between the nano sheets HL on which the nano sheet dielectric layers GD are formed.

The column array AR1 may include a vertical arrangement of the nano sheets HL in the first direction D1, the first conductive line BL coupled in common to the nano sheets HL in the vertical arrangement, and the second conductive lines WL each surrounding a different one of the nano sheets HL in the vertical arrangement.

The row array AR2 may include a horizontal arrangement of the nano sheets HL in the third direction D3, the first conductive lines BL each coupled to a different one of the nano sheets HL in the horizontal arrangement, and the second conductive line WL surrounding the nano sheets HL in the horizontal arrangement.

The first direction D1 may be a vertical direction, and the third direction D3 may be a horizontal direction.

The semiconductor device 100 illustrated in FIGS. 4 to 6 may be similar to the memory cell array MCA illustrated in FIG. 3. Hereinafter, detailed descriptions of overlapping components are omitted.

Referring to FIGS. 3, 4, 5A, 5B and 6, the semiconductor device 100 may include a memory cell array MCA, and the memory cell array MCA may include a cell array region R1 and a coupling region R2. The cell array region R1 may be a region where memory cells MC are formed, and the coupling region R2 may be a region for supplying an electrical signal to a part of the memory cells MC. The coupling region R2 may be referred to as a "pad region". The memory cell array MCA may include a lower memory cell array MCA1, an upper memory cell array MCA2, and a dummy memory cell array DMCA. The dummy memory cell array DMCA may be disposed between the lower memory cell array MCA1 and the upper memory cell array MCA2. The lower memory cell array MCA1, the upper memory cell array MCA2 and the dummy memory cell array DMCA may each include the cell array region R1 and the coupling region R2.

The coupling region R2 may include multi-level pads WLP. Each of the pads WLP may be electrically coupled to contact plugs CT. The contact plugs CT may penetrate (some or) all of the pads WLP. Contact spacers CTS may be formed on outer walls of the contact plugs CT. Each of inter-pad dielectric layers IL4 may be disposed between the pads WLP. The coupling region R2 may have a stairless structure.

The memory cell array MCA may include a plurality of memory cells MC vertically stacked in a first direction D1. The memory cells MC may have the same configuration as the memory cells MC described with reference to FIGS. 1 and 2. The memory cell array MCA may include a plurality of memory cells MC horizontally disposed in a second direction D2. The memory cell array MCA may include a plurality of memory cells MC horizontally disposed in a third direction D3. The memory cell array MCA may include a plurality of first conductive lines BL. Switching elements TR of the memory cells MC may be nano sheet transistors.

The first conductive lines BL may vertically extend in the first direction D1, a nano sheet HL may extend in the second direction D2, and a second conductive line WL may horizontally extend in the third direction D3.

Each of first inter-cell dielectric layers IL1 may be disposed between data storage elements CAP adjacent to each other in the third direction D3. Each of second inter-cell dielectric layers IL2 may be disposed between second conductive lines WL that are vertically stacked in the first direction D1. Each of third inter-cell dielectric layers IL3 may be disposed between first electrodes SN of the data storage elements CAP that are vertically stacked in the first direction D1. The first to third inter-cell dielectric layers IL1, IL2 and IL3 may each include silicon oxide, silicon carbon oxide (SiCO), silicon nitride, or a combination thereof. The first inter-cell dielectric layers IL1 may be referred to as "device isolation layers".

Each of the memory cells MC may further include a first contact node BLC and a second contact node SNC. The first contact node BLC may be disposed between the first conductive line BL and the nano sheet HL. The first contact node BLC may include a metal-based material or a semiconductive material. For example, the first contact node BLC may include titanium, titanium nitride, tungsten, or a combination thereof. In addition, the first contact node BLC may include doped polysilicon, and a first doped region SR may include an impurity diffused from the first contact node BLC. The second contact node SNC may be disposed between the nano sheet HL and the first electrode SN. The second contact node SNC may include a metal-based material or a semiconductive material. For example, the second contact node SNC may include titanium, titanium nitride, tungsten, or a combination thereof. In addition, the second contact node SNC may include doped polysilicon, and a second doped region DR may include an impurity diffused from the second contact node SNC. A height of the first contact node BLC in the first direction D1 may be less than a height of the second contact node SNC in the first direction D1. The height of the first contact node BLC in the first direction D1 may be greater than a height of a channel CH in the first direction D1.

The memory cell MC may further include an ohmic contact layer (refer to reference symbol "BLO" of FIG. 3) between the first contact node BLC and the first conductive line BL. The ohmic contact layer may include metal silicide, such as titanium silicide or molybdenum silicide.

The memory cell MC may further include a first spacer SP1 and a second spacer SP2. The first spacer SP1 may be disposed between the second conductive line WL and the second doped region DR. The second spacer SP2 may be disposed between the first conductive line BL and the second conductive line WL. The first and second spacers SP1 and SP2 may each include silicon oxide, silicon nitride, or a combination thereof. The first spacer SP1 may cover one side of the second inter-cell dielectric layers IL2. The first spacer SP1 may have a cup shape.

The memory cell array MCA may include a plurality of second conductive lines WL that are vertically stacked in the first direction D1. The memory cell array MCA may include a plurality of nano sheets HL that are vertically stacked in the first direction D1. The memory cell array MCA may include a plurality of data storage elements CAP that are vertically stacked in the first direction D1. The memory cell array MCA may include a plurality of first conductive lines BL spaced apart in the third direction D3.

The multi-level second conductive lines WL may each include an extension portion WLE, and each edge portion WP of pads WLP may be disposed in an inner space or an inner surface of the extension portion WLE. Each extension portion WLE of the second conductive lines WL may be electrically coupled to a different one of the pads WLP. The extension portions WLE of the second conductive lines WL and the edge portions WP of the pads WLP may contact a third spacer SP3. The extension portions WLE of the second conductive lines WL may each have a concave shape, and the edge portions WP of the pads WLP may each have a convex shape. A vertical stack of the pads WLP may have a stairless structure.

The pads WLP may (each and all) contact a (same) pad support layer WSL. The pad support layer WSL may be disposed between the pads WLP adjacent to each other in the second direction D2. For example, a first pad WLP1 may be disposed to the left of the pad support layer WSL while a second pad WLP2 may be disposed to the right of the pad support layer WSL.

The third spacer SP3 may be disposed between the second inter-cell dielectric layers IL2 and the inter-pad dielectric layers IL4. The first spacer SP1 and the third spacer SP3 may be the same material.

The memory cell array MCA may include a plurality of first and second bottom passivation layers BT1 and BT2. The first bottom passivation layer BT1 may prevent a bottom surface of the first conductive line BL and a lower structure LS from coming into electrical contact with each other. The second bottom passivation layer BT2 may prevent the data storage element CAP and the lower structure LS from coming into electrical contact with each other.

A vertical isolation layer BLF may be disposed between the first conductive lines BL. The vertical isolation layer BLF may include a dielectric material.

The nano sheets HL of the switching elements TR that are horizontally disposed in the third direction D3 may share one second conductive line WL. The nano sheets HL of the switching elements TR that are horizontally disposed in the third direction D3 may be coupled to different first conductive lines BL. The switching elements TR that are stacked in the first direction D1 may share one first conductive line BL. The switching elements TR that are horizontally disposed in the third direction D3 may share one second conductive line WL.

A pair of second conductive lines WL that are horizontally spaced apart in the second direction D2 may share one pad WLP.

Second electrodes PN of the data storage elements CAP may be coupled to a common plate PL.

As described above, the lower memory cell array MCA1, the upper memory cell array MCA2 and the dummy memory cell array DMCA may each include a plurality of memory cells MC and a plurality of pads WLP. The lower memory cell array MCA1, the upper memory cell array MCA2 and the dummy memory cell array DMCA may include the memory cells MC having the same structure. The lower memory cell array MCA1, the upper memory cell array MCA2 and the dummy memory cell array DMCA may include the pads WLP having the same structure. The vertical stack of the pads WLP may have the stairless structure.

Referring to FIGS 5A and 5B, in the coupling region R2, the first pad stack PS1 may include a vertical arrangement of first pads electrically coupled to the first memory cells of memory cell array MCA1.

The second pad stack PS2 may be vertically disposed over the first pad stack PS1 and may include a vertical arrangement of second pads electrically coupled to memory cells of the second memory cell array MCA2. A dummy pad stack DPS may be vertically disposed between the first pad stack PS1 and the second pad stack PS2, and may include a vertical arrangement of dummy pads DWLP.

The contact plugs CT may penetrate the second pad stack PS2, the dummy pad stack DPS, and the first pad stack PS1. The contact plugs CT may penetrate the second pad stack PS2 and the dummy pad stack DPS, and may be connected to one of the first pads included in the first pad stack PS1. The contact plugs CT may also be connected to one of the second pads of the second pad stack PS2.

In an embodiment, as illustrated in FIG. 5A, the dummy pad stack DPS may include dummy pads DWLP each having flat upper and lower surfaces.

In another embodiment, as illustrated in FIG. 5B, the dummy pad stack is referred to as NDPS and has a structure different from that of FIG. 5A. The dummy pad stack NDPS may include a first dummy pad DWLP_L having a non-flat upper surface and a flat lower surface, a second dummy pad DWLP_H having a non-flat lower surface and a flat upper surface, and an inter-pad dielectric layer DIL4 disposed between the first dummy pad DWLP_L and the second dummy pad DWLP_H.

The non-flat upper surface of the first dummy pad and the non-flat lower surface of the second dummy pad may be disposed to face each other with the inter-pad dielectric layer therebetween. The non-flat upper surface of the first dummy pad may include a curved profile or an angled profile. The non-flat upper surface of the first dummy pad may also include a domed profile.

The non-flat upper surface of the first dummy pad may include a convex profile, and the non-flat lower surface of the second dummy pad may include a concave profile, and the convex profile and the concave profile may be disposed to face each other. The convex profile of the first dummy pad and the concave profile of the second dummy pad may be disposed to face each other with the inter-pad dielectric layer therebetween. The first dummy pad DWLP_L may include the non-flat upper surface having a slope toward a sidewall of the contact plug CT, and the second dummy pad DWLP_H may include the non-flat lower surface having a slope toward the sidewall of the contact plug CT. The non-flat upper surface and the non-flat lower surface each having the slope toward the sidewall of the contact plug CT may be disposed to face each other with the inter-pad dielectric layer therebetween.

Contact spacers CTS may be formed on outer walls of the contact plugs CT. The first dummy pad and the second dummy pad near the contact spacers CTS may have rounded edges or recesses, as shown in FIG. 5B.

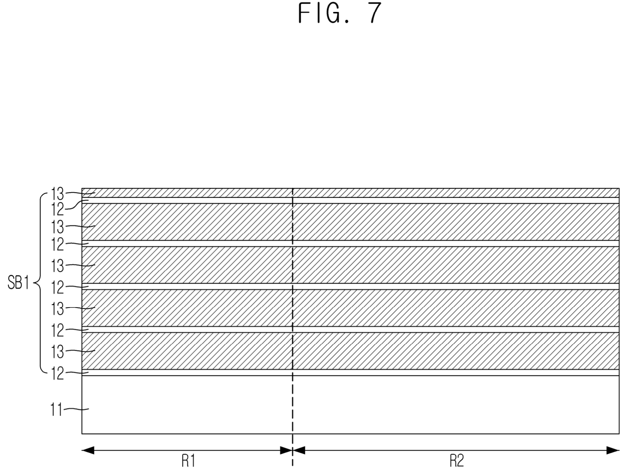

FIGS. 7 to 29B illustrate various views of a semiconductor device formed utilizing a method for fabricating the semiconductor device in accordance with an embodiment of the present disclosure. A method for fabricating the semiconductor device 100 taken along line A-A' illustrated in FIG. 4 is described with reference to FIGS. 7 to 29B.

Referring to FIG. 7, a first mold stack SB1 may be formed on a substrate 11. The first mold stack SB1 may include an alternating stack of first mold layers 12 and second mold layers 13. The first mold layers 12 and the second mold layers 13 may be different semiconductive materials. The first mold layers 12 may each include silicon germanium or monocrystalline silicon germanium. The second mold layers 13 may each include monocrystalline silicon. The first mold layers 12 and the second mold layers 13 may be formed by an epitaxial growth process. A lowermost first mold layer 12 may serve as a seed layer during the epitaxial growth process. Each of the first mold layers 12 may be thinner than each of the second mold layers 13. The first mold layers 12 may include first epitaxially grown layers, and the second mold layers 13 may include second epitaxially grown layers.

In an embodiment, a plurality of monocrystalline silicon germanium layers may be alternately stacked with a plurality of monocrystalline silicon layers in the first mold stack SB1. For example, the first mold layers 12 may be the monocrystalline silicon germanium layers, and the second mold layers 13 may be the monocrystalline silicon layers. A stack of a monocrystalline silicon germanium layer and a monocrystalline silicon layer (a SiGe/Si stack) may be stacked multiple times. The first mold layers 12 may be referred to as "sacrificial layers", and the second mold layers 13 may be referred to as "nano sheet target layers" or "recess target layers".

The first mold stack SB1 may be referred to as a "first vertical stack". The first mold stack SB1 may be formed by alternately stacking a plurality of sacrificial layers and a plurality of nano sheet target layers. The sacrificial layers may be monocrystalline silicon germanium layers, and the nano sheet target layers may be monocrystalline silicon layers.

A ratio of a thickness of the first mold layers 12 to a thickness of the second mold layers 13 in the first mold stack SB1 may be variously modified. For example, the thickness of the first mold layers 12 may be 5 to 20 nm, and the thickness of the second mold layers 13 may be 50 to 80 nm. A quantity of the first mold layers 12 and a quantity of the second mold layers 13 in the first mold stack SB1 may be variously modified. In some embodiments, a triple stack including the first mold layer 12, the second mold layer 13 and the first mold layer 12 may be defined at lowermost and/or uppermost portions of the first mold stack SB1. The second mold layer 13 of the triple stack may have a thickness less than the second mold layer 13 of the first mold stack SB1.

In an embodiment, an uppermost layer of the first mold stack SB1 may be a thin second mold layer 13.

The first mold stack SB1 may include a cell array region R1 and a coupling region R2.

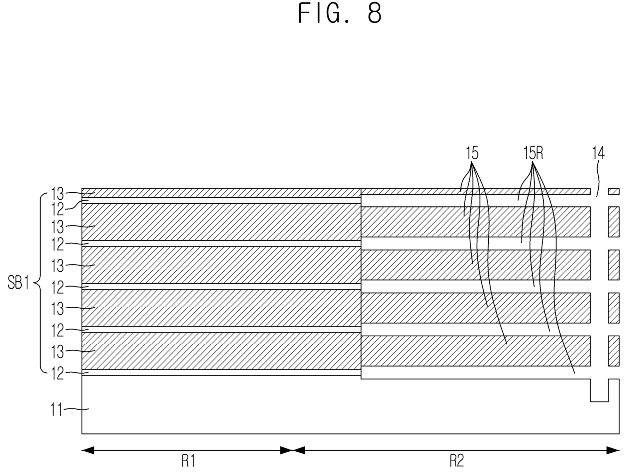

Referring to FIG. 8, a portion of the first mold stack SB1 may be etched and form first inter-pad isolation trenches 14 in the coupling region R2.

Subsequently, after the first mold layers 12 are removed from the coupling region R2 through the first inter-pad isolation trenches 14, a partial recess process may be performed on the second mold layers 13. First pad sheets 15 may be formed by the partial recess process performed on the second mold layers 13. The first pad sheets 15 of the coupling region R2 may be thinner than the second mold layers 13 of the cell array region R1. The first pad sheets 15 of the coupling region R2 and the second mold layers 13 of the cell array region R1 may be the same material formed integrally. Each of inter-pad sheet recesses 15R may be defined between the first pad sheets 15.

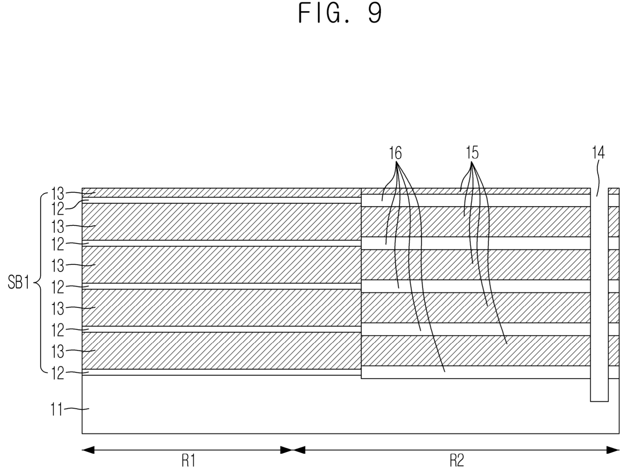

Referring to FIG. 9, first inter-pad dielectric layers 16 may be formed to fill the inter-pad sheet recesses 15R formed between the first pad sheets 15. The first inter-pad dielectric layers 16 may each include silicon oxide.

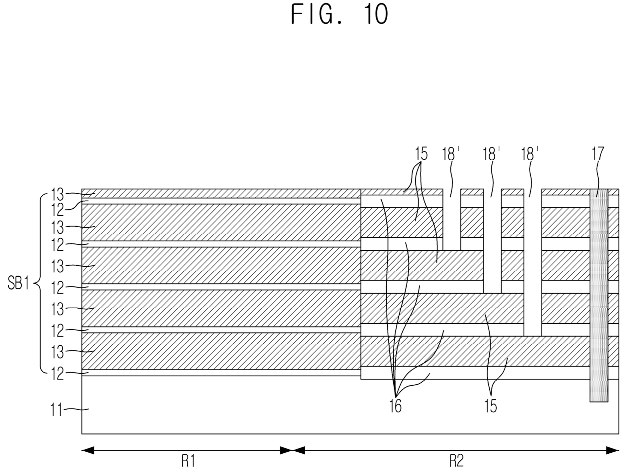

Referring to FIG. 10, a first pad isolation layer 17 may be formed to fill each of the first inter-pad isolation trenches 14. The first pad isolation layer 17 may include a dielectric material. The first pad isolation layer 17 may include silicon oxide, silicon nitride, or a combination thereof.

Subsequently, first contact holes 18' may be formed to penetrate a stack of the first inter-pad dielectric layers 16 and the first pad sheets 15. The first contact holes 18' may have different vertical depths. The first contact holes 18' may expose the first pad sheets 15 corresponding to respective levels. For example, the deepest first contact hole 18' may expose an upper surface of a lowermost first pad sheet 15 and penetrate the first pad sheets 15 at other levels.

As described above, in the coupling region R2, the second mold layers 13 may be changed to the first pad sheets 15. In addition, a first vertical stack including a vertical stack of the second mold layers 13 and a first vertical stack including a vertical stack of the first pad sheets 15 may be formed in the cell array region R1 and the coupling region R2, respectively.

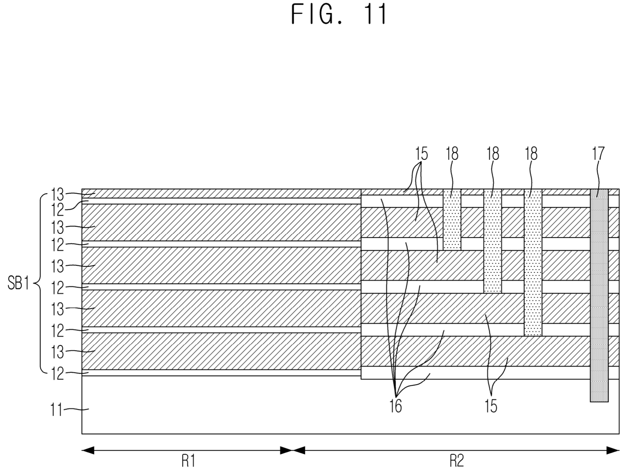

Referring to FIG. 11, first sacrificial plugs 18 may be formed to fill the first contact holes 18'. The first sacrificial plugs 18 may each include a dielectric material. In the coupling region R2, an uppermost first pad sheet 15 may be partially exposed by the first sacrificial plugs 18. In the cell array region R1, an entire surface of an uppermost second mold layer 13 may be exposed.

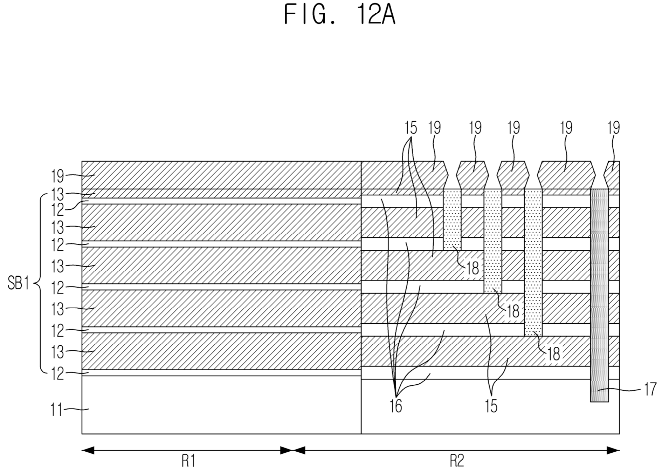

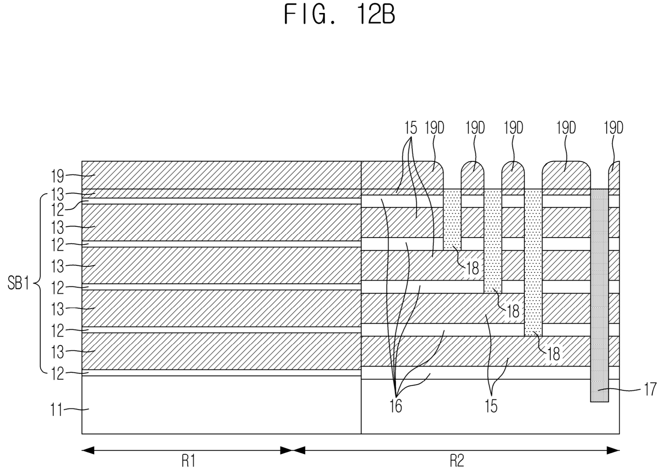

Referring to FIG. 12A and 12B, a plurality of first dummy mold layers 19 may be formed on the uppermost second mold layer 13 and the uppermost first pad sheet 15. The first dummy mold layers 19 may be selectively grown from the exposed surface of the uppermost first pad sheet 15. The first dummy mold layer 19 in the cell array region R1 formed on the uppermost second mold layer 13 may have a flat-plate shape. The first dummy mold layers 19 in the cell array region R2 formed on the uppermost first pad sheet 15 may each have a protruding shape such as the protruding shape in FIG. 12A. The first dummy mold layers 19D in the cell array region R2 formed on the uppermost first pad sheet 15 may each have a protruding shape such as the alternative protruding shape in FIG 12B. A gap may be defined between the first dummy mold layers 19D formed on the uppermost first pad sheet 15.

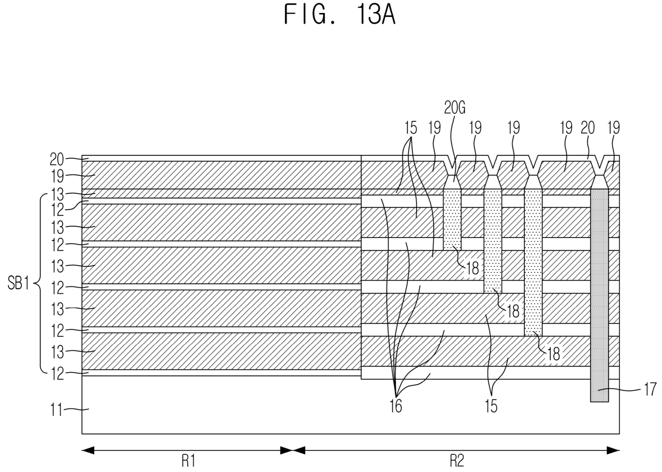

Hereinafter, FIGS. 13A to 29A are exemplary views for explaining a method of manufacturing a semiconductor device having the protruding-type first dummy mold layers 19 illustrated in FIG. 12A, and FIGS. 13B to 29B are exemplary views for explaining a method of manufacturing a semiconductor device having the protruding-type first dummy mold layers 19D illustrated in FIG. 12B.

The first dummy mold layers 19 may be the same material as the second mold layers 13. The first dummy mold layers 19 may include monocrystalline silicon. The first dummy mold layers 19 may be formed by selective epitaxial growth. In an embodiment, the first dummy mold layers 19 may include monocrystalline silicon layers. The first dummy mold layers 19 may be referred to as "dummy nano sheet target layers". The first dummy mold layers 19 may be thicker than the uppermost second mold layer 13 and the uppermost first pad sheet 15.

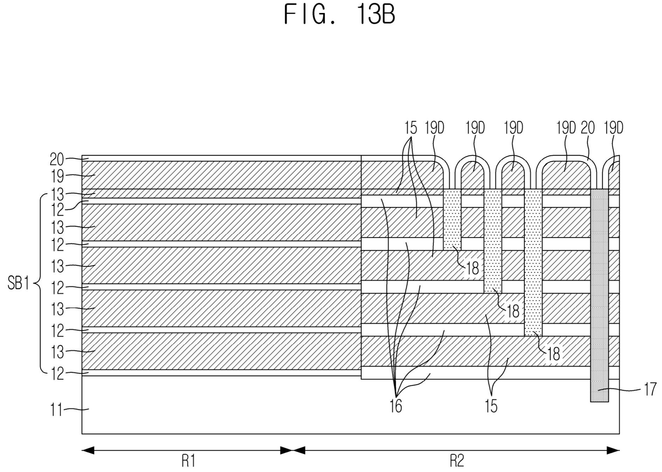

Referring to FIG. 13A, a second dummy mold layer 20 may be formed on the first dummy mold layers 19. The second dummy mold layer 20 may be epitaxially grown on the first dummy mold layers 19. Referring to FIG. 13B, a second dummy mold layer 20 may be formed on the first dummy mold layers 19D. The second dummy mold layer 20 may be epitaxially grown on the first dummy mold layers 19D. The second dummy mold layer 20 may include monocrystalline silicon germanium. The second dummy mold layer 20 may be referred to as a "dummy sacrificial layer". The second dummy mold layer 20 and the first mold layers 12 may be the same material. After the second dummy mold layer 20 is formed, a gap 20G may be formed between the first dummy mold layers 19.

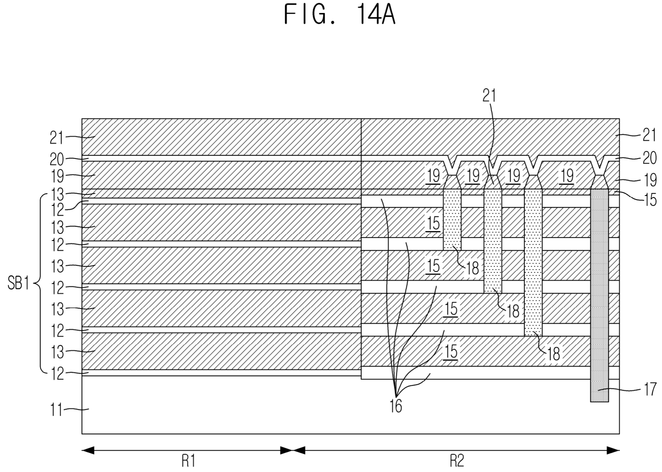

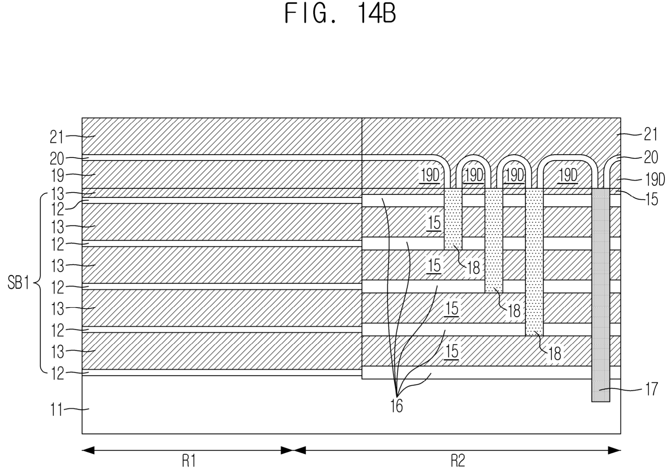

Referring to FIG. 14A and 14B, an additional dummy mold layer 21 may be formed on the second dummy mold layer 20. The additional dummy mold layer 21 may be the same material as the first dummy mold layers 19. The additional dummy mold layer 21 may include monocrystalline silicon. The additional dummy mold layer 21 may be formed by selective epitaxial growth. In an embodiment, the additional dummy mold layer 21 may include a monocrystalline silicon layer. Portions of the additional dummy mold layer 21 may fill the gap (reference numeral "20G" in FIG. 13A) between the first dummy mold layers 19 on the second dummy mold layer 20.

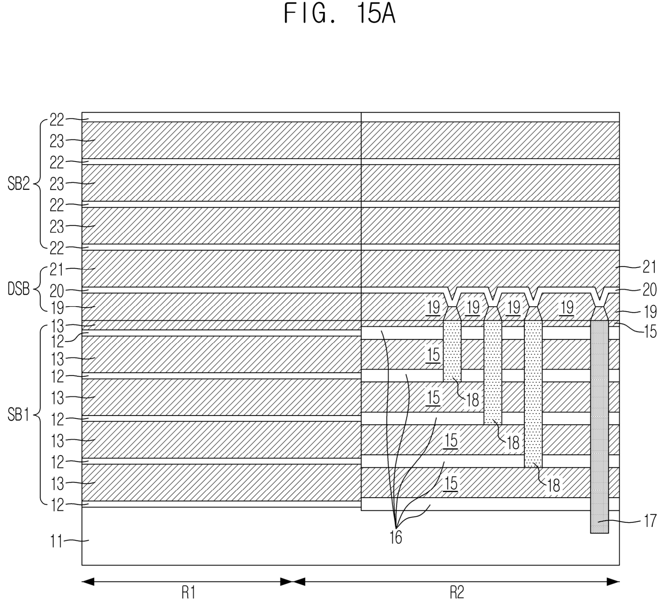

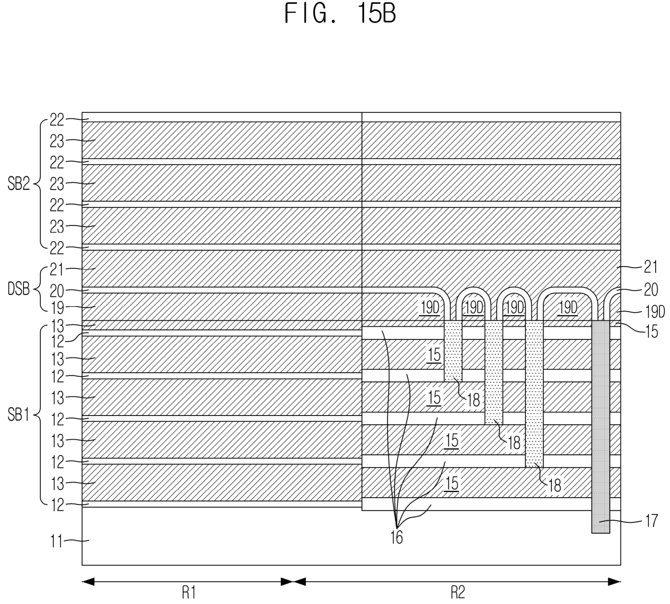

Referring to FIG. 15A, a second mold stack SB2 may be formed on the additional dummy mold layer 21. A stack of the first dummy mold layers 19, the second dummy mold layer 20 and the additional dummy mold layer 21 may become a dummy stack DSB. Referring to FIG. 15B, a stack of the first dummy mold layers 19 and 19D, the second dummy mold layer 20 and the additional dummy mold layer 21 may become a dummy stack DSB. The dummy stack DSB may be formed on the first mold stack SB1, and the second mold stack SB2 may be formed on the dummy stack DSB.

In some embodiments, a quantity of first dummy mold layers 19 and 19D, a quantity of second dummy mold layers 20 and a quantity of additional dummy mold layers 21 may be variously modified to form the dummy stack DSB.

The second mold stack SB2 may include an alternating stack of first mold layers 22 and second mold layers 23. The first mold layers 22 and the second mold layers 23 may be different semiconductive materials. The first mold layers 22 may each include silicon germanium or monocrystalline silicon germanium. The second mold layers 23 may each include monocrystalline silicon. The first mold layers 22 and the second mold layers 23 may be formed by an epitaxial growth process. Each of the first mold layers 22 may be thinner than each of the second mold layers 23. The first mold layers 22 may include first epitaxially grown layers, and the second mold layers 23 may include second epitaxially grown layers.

In an embodiment, a plurality of monocrystalline silicon germanium layers may be alternately stacked with a plurality of monocrystalline silicon layers in the second mold stack SB2. For example, the first mold layers 22 may be the monocrystalline silicon germanium layers, and the second mold layers 23 may be the monocrystalline silicon layers. A stack of a monocrystalline silicon germanium layer and a monocrystalline silicon layer (a SiGe/Si stack) may be stacked multiple times. The first mold layers 22 may be referred to as "sacrificial layers", and the second mold layers 23 may be referred to as "nano sheet target layers" or "recess target layers".

The second mold stack SB2 may be referred to as a "second vertical stack". The second mold stack SB2 may be formed by alternately stacking a plurality of sacrificial layers and a plurality of nano sheet target layers. The sacrificial layers may be monocrystalline silicon germanium layers, and the nano sheet target layers may be monocrystalline silicon layers.

A ratio of a thickness of the first mold layers 22 to a thickness of the second mold layers 23 in the second mold stack SB2 may be variously modified. For example, the thickness of the first mold layers 22 may be 5 to 20 nm, and the thickness of the second mold layers 23 may be 50 to 80 nm. A quantity of the first mold layers 22 and a quantity of the second mold layers 23 in the second mold stack SB2 may be variously modified.

In an embodiment, an uppermost layer of the second mold stack SB2 may be a thin first mold layer 22.

The second mold stack SB2 may include the cell array region R1 and the coupling region R2.

The first mold layers 12 of the first mold stack SB1 and the first mold layers 22 of the second mold stack SB2 may be the same material. The first mold layers 12 of the first mold stack SB1 and the first mold layers 22 of the second mold stack SB2 may have the same thickness. The second mold layers 13 of the first mold stack SB1 and the second mold layers 23 of the second mold stack SB2 may be the same material. The second mold layers 13 of the first mold stack SB1 and the second mold layers 23 of the second mold stack SB2 may have the same thickness. The second mold layers 13 and 23 of the first and second mold stacks SB1 and SB2 may be referred to as "semiconductor layers", and the first, second and additional dummy mold layers 19, 20 and 21 of the dummy stack DSB may be referred to as "dummy semiconductor layers".

Vertical heights of the first and second mold stacks SB1 and SB2 may be greater than a vertical height of the dummy stack DSB.

The dummy stack DSB may be a region where dummy memory cells are formed, and the first and second mold stacks SB1 and SB2 may be a region where real memory cells are formed.

For example, when 100-step memory cells are formed, the first mold stack SB1 may be formed with 50 steps, and the second mold stack SB2 may be formed with 50 steps. After the 50-step first mold stack SB1, an epitaxial growth process may be performed on the second mold layers 13, and the dummy stack DSB may be formed. After the dummy stack DSB is formed, the 50-step second mold stack SB2 may be formed. The first dummy mold layers 19, the second dummy mold layer 20 and the additional dummy mold layer 21 of the dummy stack DSB, which are abnormally-grown epitaxial layers, may process the abnormal epitaxial layers as dummy layers.

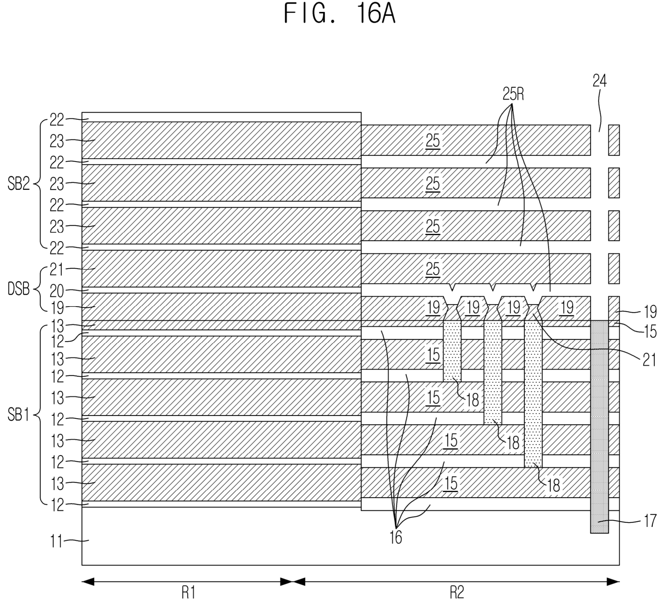

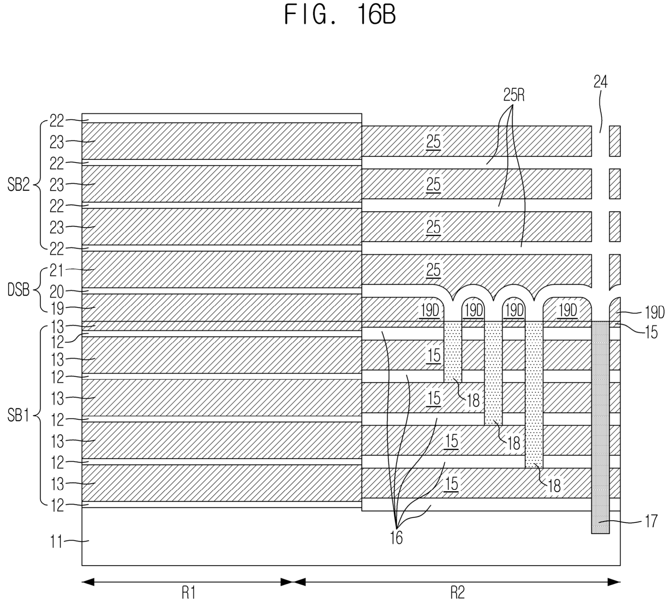

Referring to FIG. 16A and 16B, the second mold stack SB2 and the dummy stack DSB may be etched in the coupling region R2, and second inter-pad isolation trenches 24 may be formed. The second inter-pad isolation trenches 24 may expose an upper surface of the first pad isolation layer 17.

Subsequently, after the first mold layers 22 of the second mold stack SB2 and the second dummy mold layer 20 of the dummy stack DSB are removed, a partial recess process may be performed on the second mold layers 23, the additional dummy mold layer 21 and the first dummy mold layers 19. Second pad sheets 25 may be formed by the partial recess process performed on the second mold layers 23. The second pad sheets 25 of the coupling region R2 may be thinner than the second mold layers 23 of the cell array region R1. The second pad sheets 25 of the coupling region R2 and the second mold layers 23 of the cell array region R1 may be the same material formed integrally. Each of inter-pad sheet recesses 25R may be defined between the second pad sheets 25. The additional dummy mold layer 21 may remain thinly between the first dummy mold layers 19.

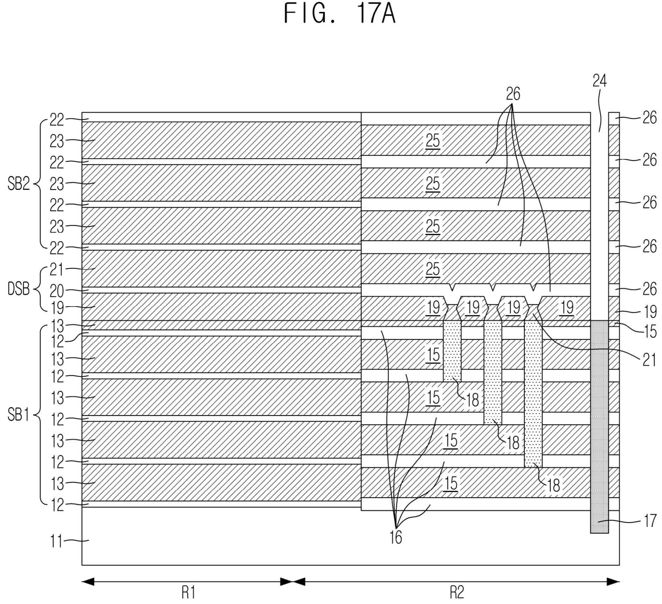

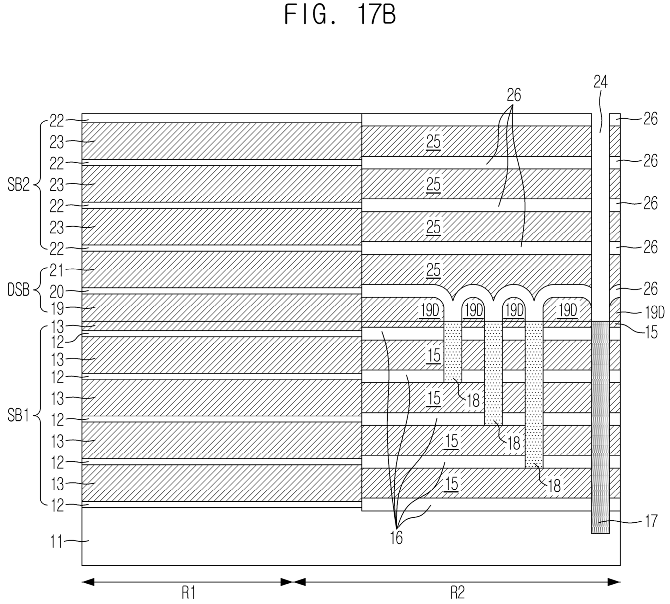

Referring to FIG. 17A and 17B, second inter-pad dielectric layers 26 may be formed to fill the inter-pad sheet recesses (reference numeral "25R" in FIG. 16A and 16B) formed between the second pad sheets 25. The second inter-pad dielectric layers 26 may each include silicon oxide.

As described above, the second mold layers 23 may be changed to the second pad sheets 25. In addition, a second vertical stack including a vertical stack of the second mold layers 23 and a second vertical stack including a vertical stack of the second pad sheets 25 may be formed in the cell array region R1 and the coupling region R2, respectively.

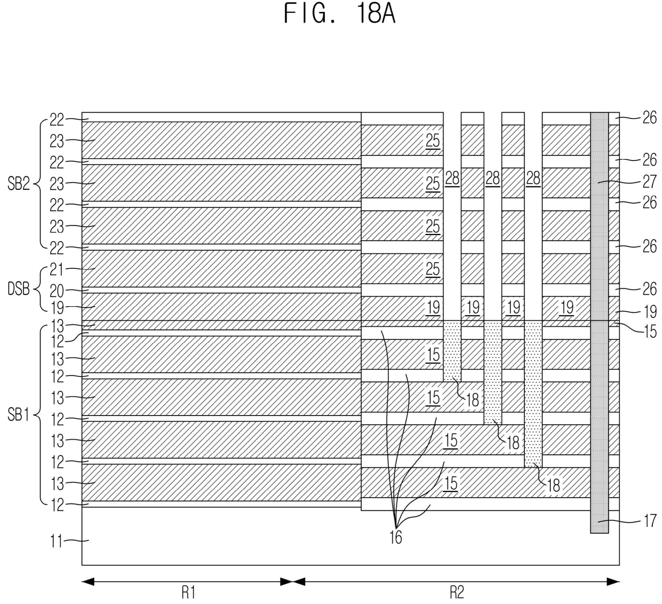

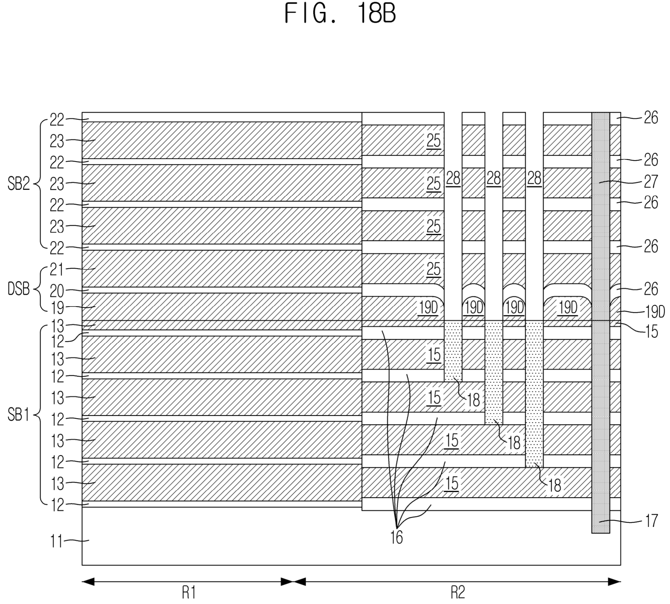

Referring to FIG. 18A and 18B, a second pad isolation layer 27 may be formed to fill each of the second inter-pad isolation trenches 24. The second pad isolation layer 27 may include silicon oxide, silicon nitride, or a combination thereof.

Subsequently, second contact holes 28 may be formed to penetrate a stack of the second inter-pad dielectric layers 26 and the second pad sheets 25. The second contact holes 28 may have the same vertical depths. The second contact holes 28 may penetrate portions of the first dummy mold layers 19 of the dummy stack DSB to expose upper surfaces of the first sacrificial plugs 18.

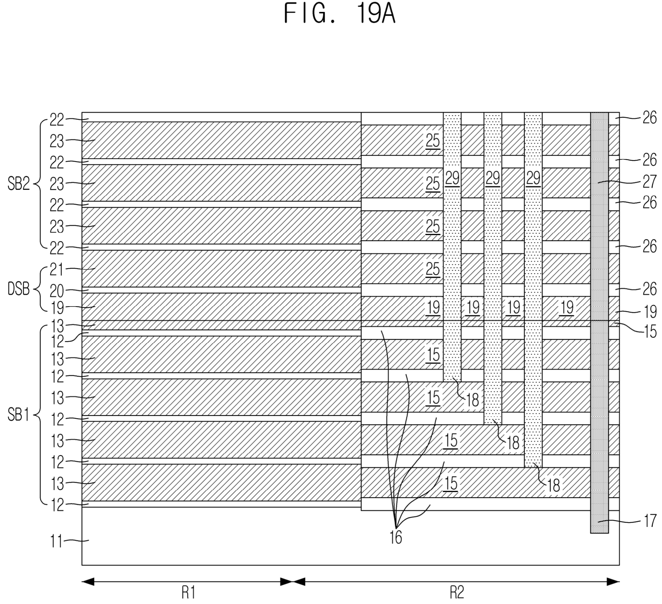

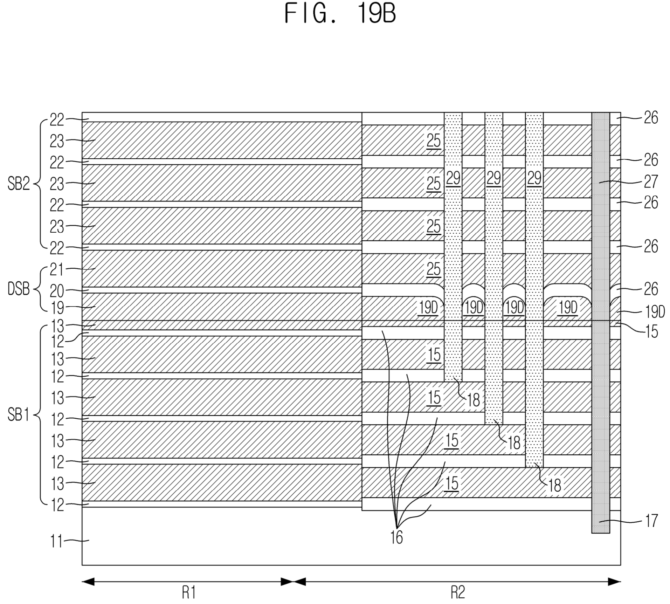

Referring to FIG. 19A and 19B, second sacrificial plugs 29 may be formed to fill the second contact holes 28. The second sacrificial plugs 29 may each include a dielectric material. In the coupling region R2, the first sacrificial plugs 18 and the second sacrificial plugs 29 may vertically overlap. The first sacrificial plugs 18 and the second sacrificial plugs 29 may be the same material.

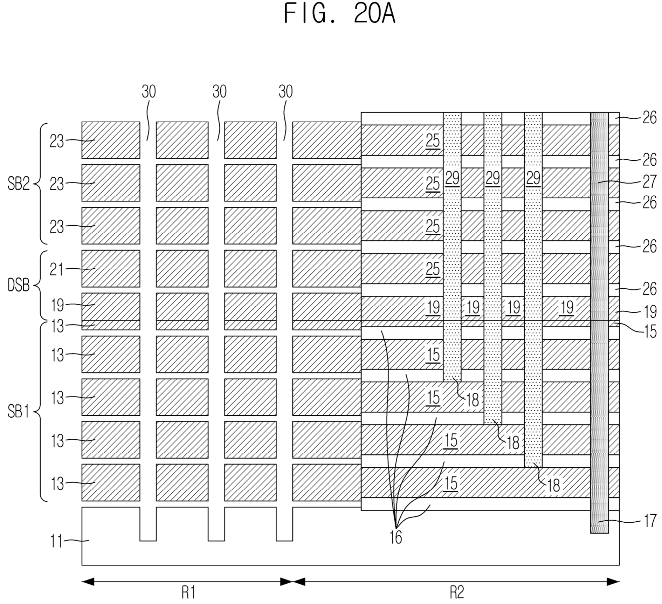

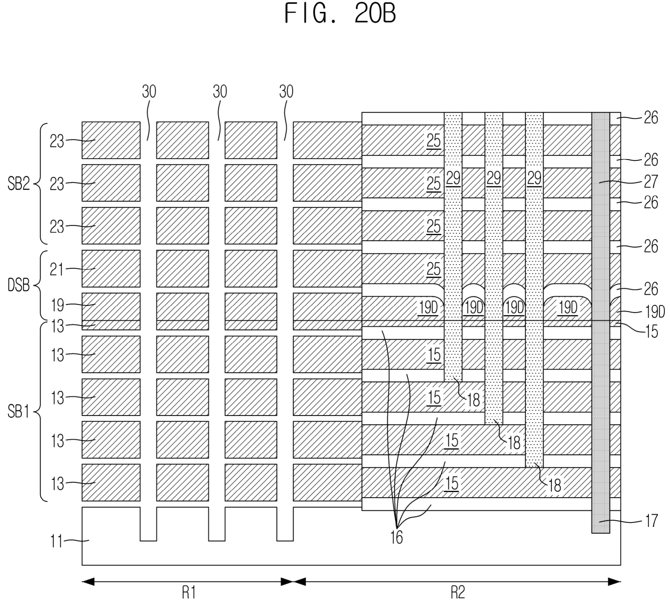

Referring to FIG. 20A and 20B, portions of the second mold stack SB2, portions of the dummy stack DSB and portions of the first mold stack SB1 may be etched in the cell array region R1. Accordingly, a plurality of linear openings 30 may be formed. From the perspective of a top view, the linear openings 30 may be line-shaped openings. The linear openings 30 may extend in a direction perpendicular to a surface of the substrate 11. Cross sections of the linear openings 30 may each have a rectangular shape.

The first mold layers 12 of the first mold stack SB1 and the first mold layers 22 of the second mold stack SB2 may be selectively recessed through the linear openings 30. To selectively recess the first mold layers 12 and 22, a difference in etch selectivity between the first mold layers 12 and 22 and the second mold layers 13 and 23 may be used. The first mold layers 12 and 22 may be removed using a wet etch or dry etch process. For example, when the first mold layers 12 and 22 include silicon germanium layers and the second mold layers 13 and 23 include monocrystalline silicon layers, the silicon germanium layers may be etched using an etchant or etch gas having a selectivity with respect to the monocrystalline silicon layers.

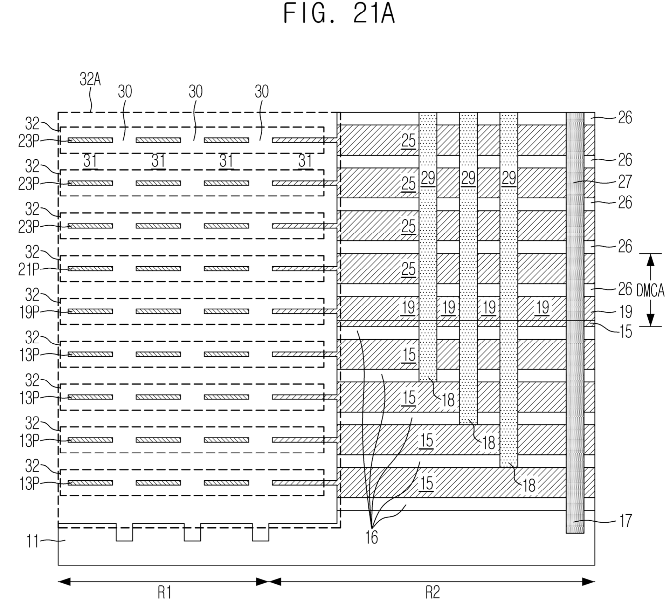

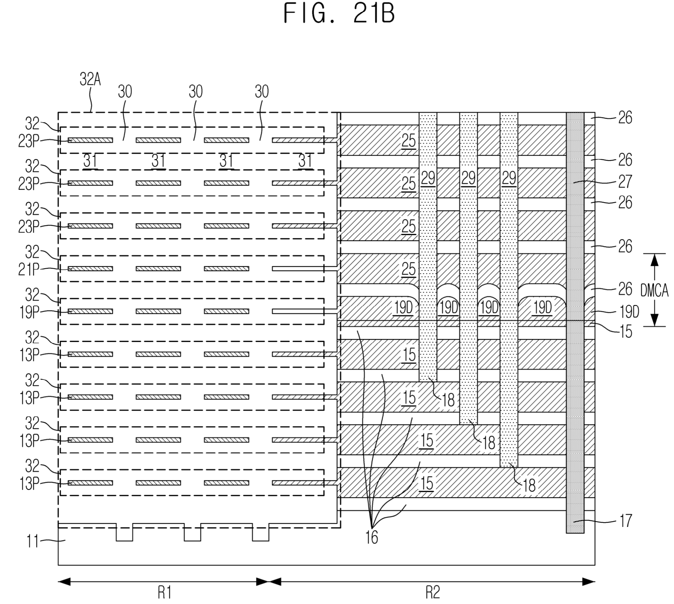

Referring to FIG. 21A and 21B, the second mold layers 13 and 23, the first dummy mold layers 19 and the additional dummy mold layers 21 may be recessed through the linear openings 30. As the second mold layers 13 and 23, the first dummy mold layers 19 and the additional dummy mold layers 21 are recessed, nano sheets 13P, 19P, 21P and 23P may be formed. The wet etch or dry etch process may be used to recess the second mold layers 13 and 23, the first dummy mold layers 19 and the additional dummy mold layers 21. The nano sheets 13P, 19P, 21P and 23P may include dummy nano sheets 19P and 21P. The dummy nano sheets 19P and 21P are formed in a dummy cell array region DMCA.

A recess process for forming the nano sheets 13P, 19P, 21P and 23P may be referred to as a "thinning process" or "trimming process" of the second mold layers 13 and 23. To form the nano sheets 13P and 23P, upper surfaces, lower surfaces and side surfaces of the second mold layers 13 and 23 may be recessed. The recess process for forming the nano sheets 13P and 23P may use, for example, Hot SC-1 (HSC1). The HSC1 may include a solution in which ammonium hydroxide (NH₄OH), hydrogen peroxide (H₂O₂) and water (H₂O) are mixed in a ratio of 1:4:20. Using the HSC1, the second mold layers 13 and 23 may be selectively etched. During the recessing of the second mold layers 13 and 23, the first dummy mold layers 19 and the additional dummy mold layers 21 may also be recessed to form the dummy nano sheets 19P and 21P.

The nano sheets 13P and 23P may be formed by the partial recess process for the second mold layers 13 and 23 as described above, and inter-nano sheet recesses 31 may be formed between the nano sheets 13P and 23P that are vertically disposed. The nano sheets 13P and 23P may include horizontal arrangements and vertical arrangements. The nano sheets 13P and 23P in the horizontal arrangements may include horizontal gaps between the nano sheets 13P and 23P that are horizontally spaced apart. The nano sheets 13P and 23P in the vertical arrangements may include vertical gaps between the nano sheets 13P and 23P that are vertically spaced apart.

A nano sheet all-open recess 32A that opens all the nano sheets 13P, 19P, 21P, and 23P in the horizontal and vertical arrangements may be formed in the cell array region R1. The nano sheet all-open recess 32A may include a plurality of surrounding recesses 32. The surrounding recesses 32 may expose the nano sheets 13P, 19P, 21P and 23P in the horizontal arrangements. For example, one surrounding recess 32 may surround all surfaces of the nano sheets 13P, 19P, 21P and 23P at the same horizontal level.

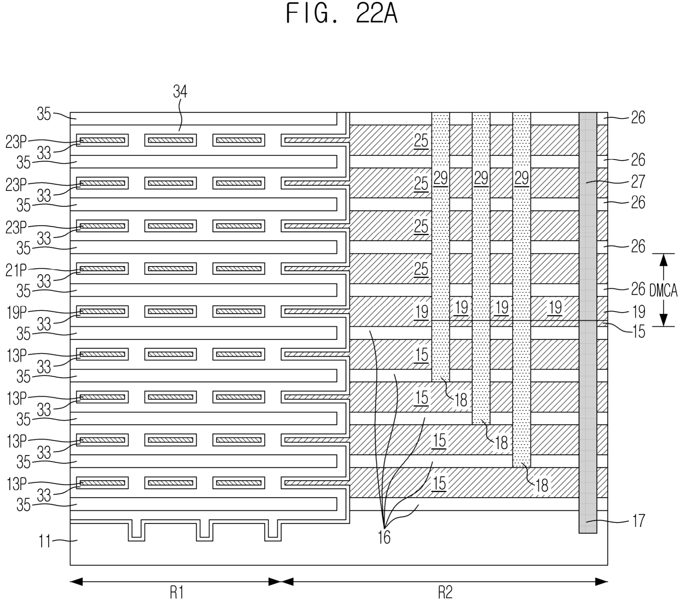

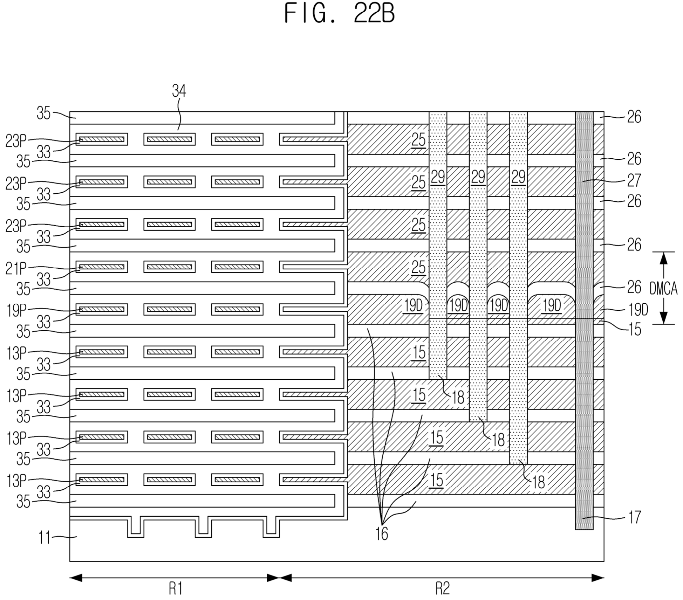

Referring to FIG. 22A and 22B a nano sheet dielectric layer 33 may be formed on exposed portions of the nano sheets 13P, 19P, 21P and 23P. The nano sheet dielectric layer 33 may be referred to as a gate dielectric layer. The nano sheet dielectric layer 33 may be formed by oxidizing the surfaces of the nano sheets 13P, 19P, 21P and 23P. In some embodiments, the nano sheet dielectric layer 33 may be formed by deposition and oxidation processes of silicon oxide. The nano sheet dielectric layer 33 may include silicon oxide, silicon nitride, metal oxide, metal oxide nitride, metal silicate, a high-k material, a ferroelectric material, an anti-ferroelectric material, or a combination thereof. The nano sheet dielectric layer 33 may include SiO₂, Si₃N₄, HfO₂, Al₂O₃, ZrO₂, AlON, HfON, HfSiO, HfSiON, or a combination thereof. The nano sheet dielectric layer 33 may be formed on all the surfaces of the nano sheets 13P, 19P, 21P and 23P.

A first spacer layer 34 may be formed on the nano sheet dielectric layer 33. The first spacer layer 34 may include silicon nitride. The first spacer layer 34 may surround and cover the nano sheets 13P, 19P, 21P and 23P on the nano sheet dielectric layer 33. The first spacer layer 34 may be thicker than the nano sheet dielectric layer 33.

Inter-cell dielectric layers 35 may be formed on the first spacer layer 34. The inter-cell dielectric layers 35 may each include silicon oxide.

The nano sheet dielectric layer 33 and the first spacer layer 34 may also be formed on the surface of the substrate 11.

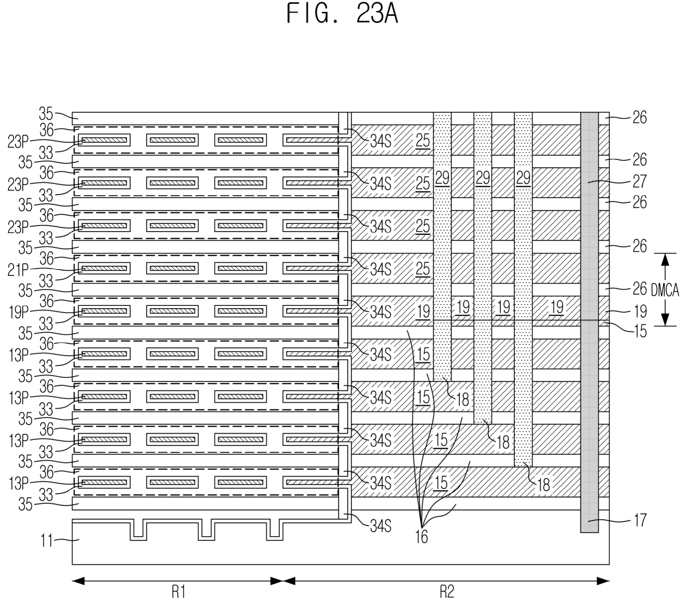

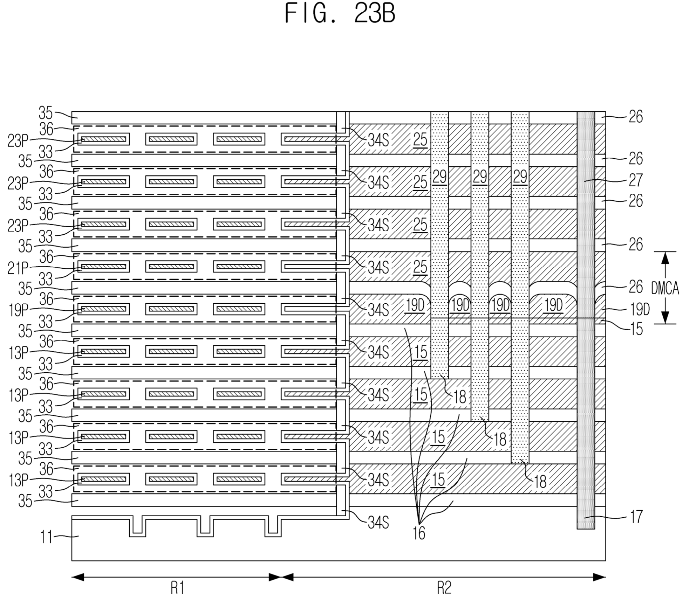

Referring to FIG. 23A and 23B, the first spacer layers 34 may be selectively recessed. The first spacer layers remaining in the coupling region R2 may become boundary spacers 34S. As the boundary spacers 34S are formed, linear surrounding recesses 36 surrounding the nano sheets 13P, 19P, 21P and 23P may be formed on the nano sheet dielectric layers 33. Each of the inter-cell dielectric layers 35 may be disposed between the linear surrounding recesses 36 that are vertically disposed. The inter-cell dielectric layers 35 may correspond to the second inter-cell dielectric layers IL2 illustrated in FIGS. 5A, 5B and 6. Each of the boundary spacer 34S may correspond to the third spacer SP3 illustrated in FIG. 5A and 5B.

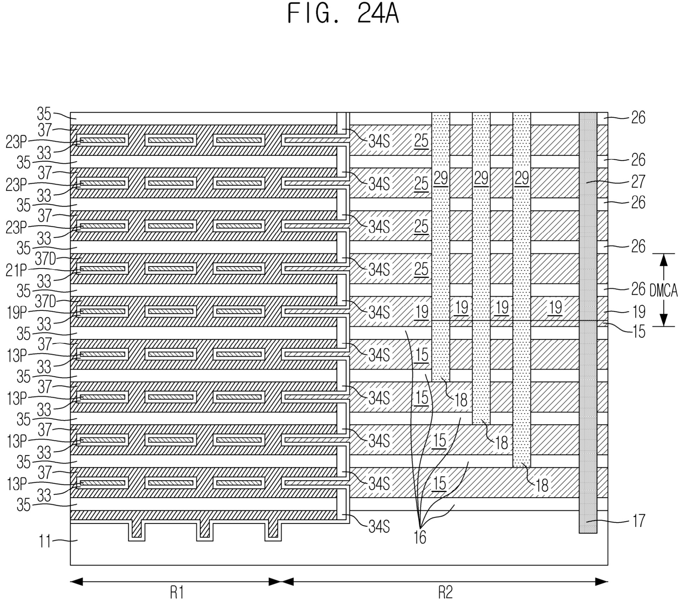

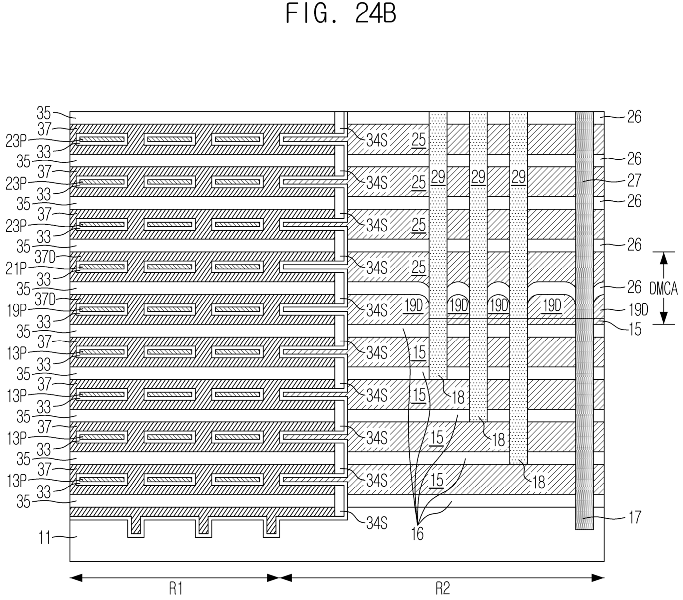

Referring to FIG. 24A and 24B, horizontal conductive lines 37 filling the linear surrounding recesses 36 may be formed. The horizontal conductive lines 37 may horizontally extend. Forming the horizontal conductive lines 37 may include depositing a conductive material filling the linear surrounding recesses 36 on the nano sheet dielectric layers 33 and performing a horizontal etch-back process on the conductive material. Each of the horizontal conductive lines 37 may simultaneously surround the nano sheets 13P, 19P, 21P and 23P at the same level. The horizontal conductive lines 37 may each include a metal-based material, a semiconductive material, or a combination thereof. The horizontal conductive lines 37 may each include molybdenum, molybdenum nitride, ruthenium, titanium nitride, tungsten, polysilicon, or a combination thereof. For example, the horizontal conductive lines 37 may each include a TiN/W stack in which titanium nitride and tungsten are sequentially stacked. The horizontal conductive lines 37 may each include an N-type work function material or a P-type work function material. The N-type work function material may have a low work function of approximately 4.5 eV or less, and the P-type work function material may have a high work function of approximately 4.5 eV or greater. Each of the inter-cell dielectric layers 35 may be disposed between a plurality of horizontal conductive lines 37. The horizontal conductive lines 37 surrounding the nano sheets 13P, 19P, 21P and 23P may be referred to as "gate-all-around (GAA) electrodes". The nano sheets 13P, 19P, 21P and 23P may be referred to as "nano sheet channels", "nano wires", or "nano wire channels".

Some of the horizontal conductive lines 37 may be disposed in the dummy cell array region DMCA. That is, some of the horizontal conductive lines 37 may be dummy horizontal conductive lines 37D surrounding the dummy nano sheets 19P and 21P.

The horizontal conductive lines 37 may correspond to the second conductive lines WL described with reference to FIGS. 3 and 4.

The horizontal conductive lines 37 may include extension portions 37E each having a concave shape.

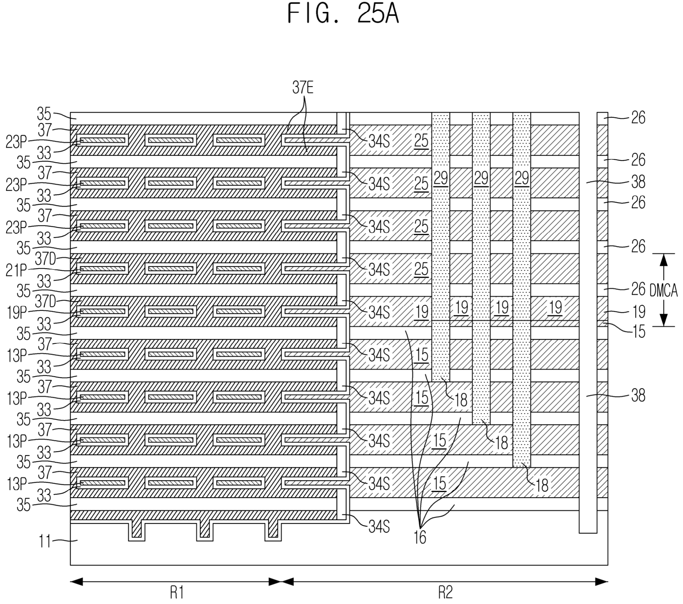

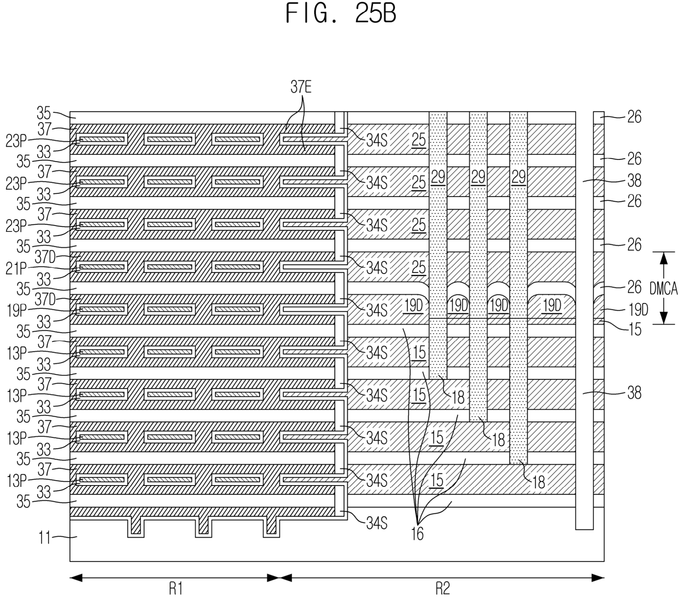

Referring to FIG. 25A and 25B, the first and second pad isolation layers 17 and 27 may be removed. Accordingly, a merged trench 38 may be formed. The merged trench 38 may have an integral structure of penetrating the first pad sheets 15, the second pad sheets 25 and the first and second inter-pad dielectric layers 16 and 26.

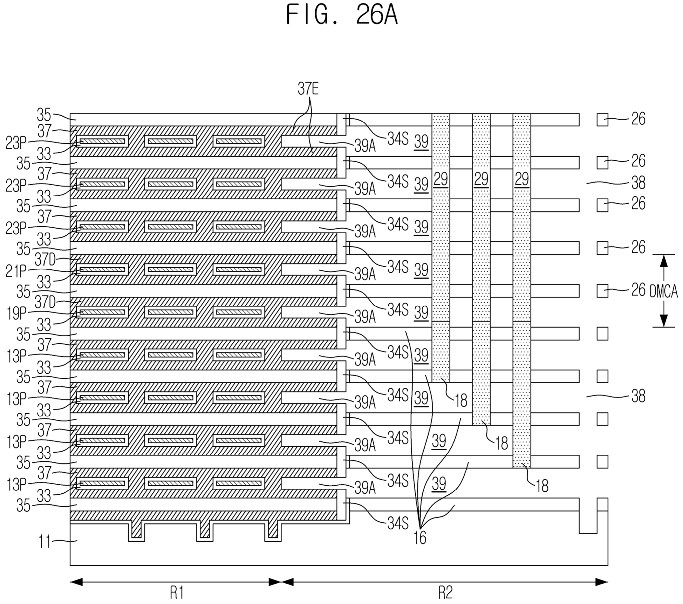

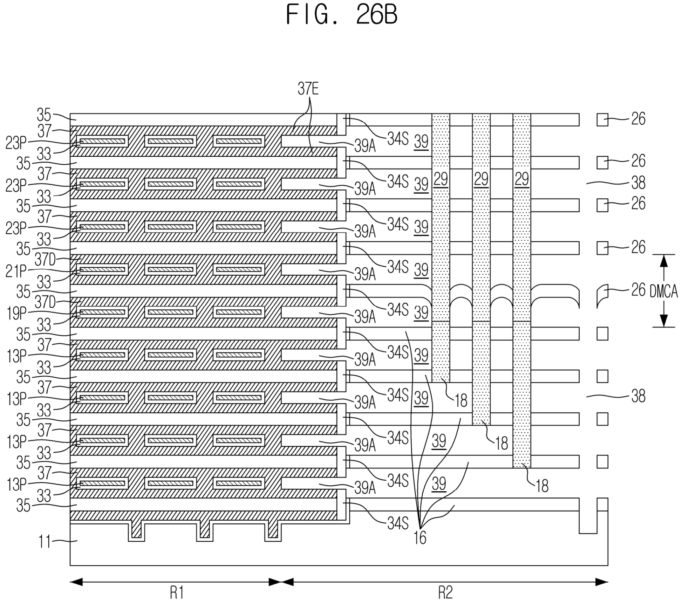

Referring to FIG. 26A and 26B, the first pad sheets 15 and the second pad sheets 25 may be selectively removed through the merged trench 38. Subsequently, portions of the nano sheet dielectric layer 33 may be cut. Accordingly, the extension portions 37E of the horizontal conductive lines 37 and the second inter-pad dielectric layers 26 may be exposed. Accordingly, pad-shaped recesses 39 may be formed. The pad-shaped recesses 39 may include edge portions 39A, and the edge portions 39A of the pad-shaped recesses 39 may expose the extension portions 37E of the horizontal conductive lines 37.

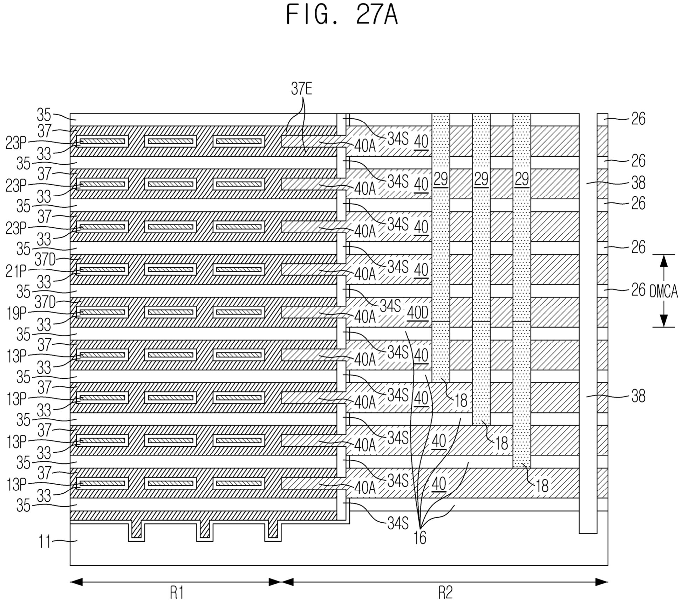

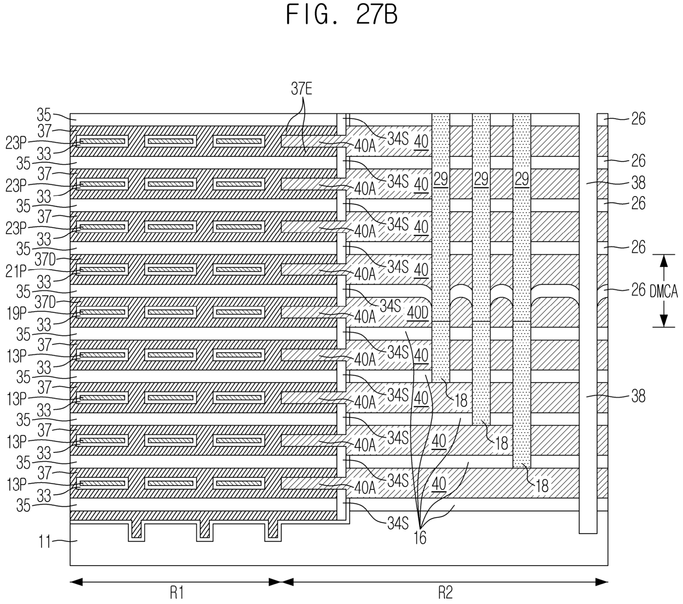

Referring to FIG. 27A and 27B, pads 40 filling the pad-shaped recesses 39 may be formed. The pads 40 may include pad edge portions 40A, and the pad edge portions 40A of the pads 40 may contact the extension portions 37E of the horizontal conductive lines 37. The pad edge portions 40A may each have a convex shape. Among the pads 40, pads that contact extension portions of the dummy horizontal conductive lines 37D may be referred to as "dummy pads".

As described above, the first and second pad sheets 15 and 25 may be replaced with the pads 40 through a series of processes.

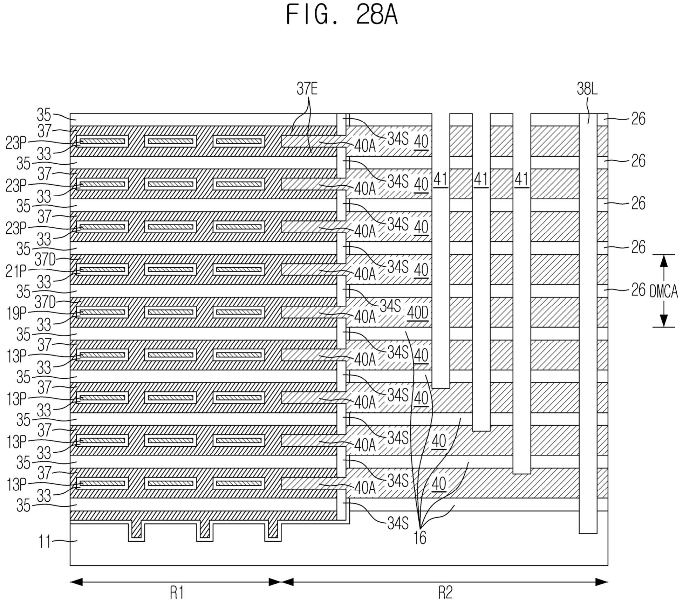

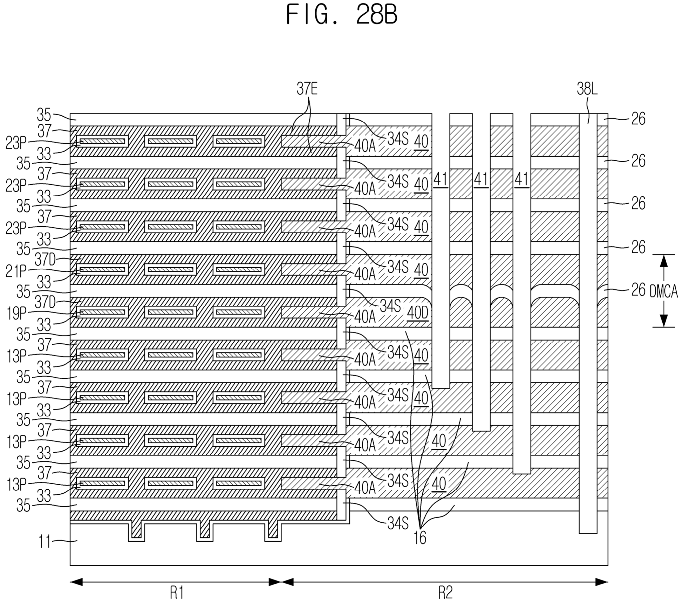

Referring to FIG. 28A and 28B, a line-shaped pad isolation layer 38L may be formed in the merged trench 38. The line-shaped pad isolation layer 38L may include a dielectric material. The line-shaped pad isolation layer 38L may be referred to as a "supporter" or a "slit".

Subsequently, the first and second sacrificial plugs 18 and 29 may be removed, and contact holes 41 may be formed. The contact holes 41 may refer to a combination of the first contact holes 18' and the second contact holes 28.

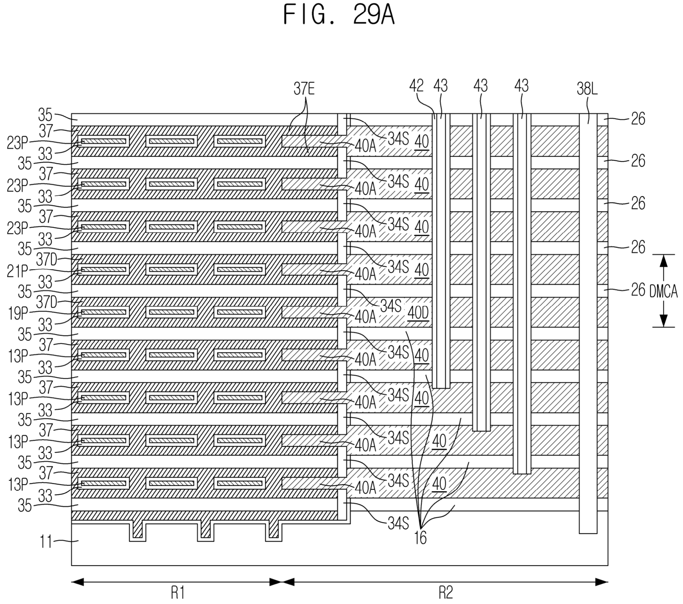

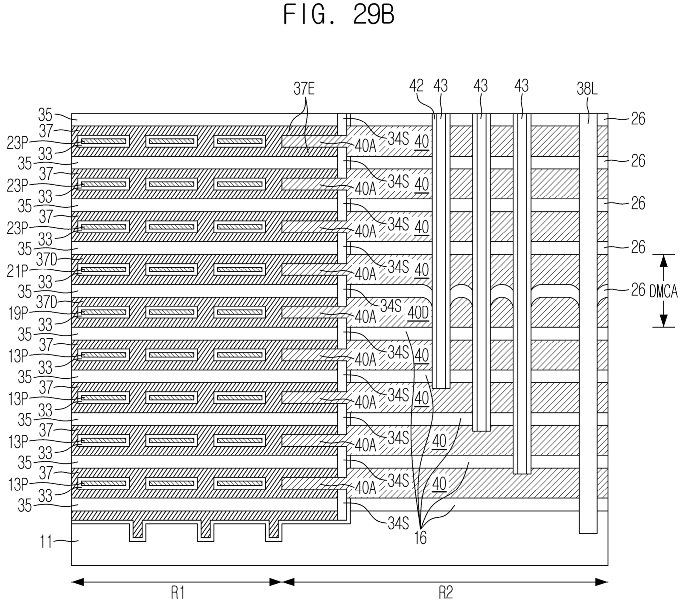

Referring to FIG. 29A and 29B, contact spacers 42 may be formed on sidewalls of the contact holes 41. The contact spacers 42 may each include a dielectric material.

Subsequently, contact plugs 43 filling the contact holes 41 may be formed on the contact spacers 42. The contact plugs 43 may each include a conductive material. The contact plugs 43 may each include a metal-based material.

As described above, the first and second sacrificial plugs 18 and 29 may be replaced with the contact plugs 43.

Subsequently, as described with reference to FIGS. 3 and 4, a first conductive line BL and data storage elements CAP may be formed.

According to various embodiments of the present disclosure, the dummy stack DSB may be formed between the first mold stack SB1 and the second mold stack SB2. Accordingly, an etch process for forming the first contact holes 18' and the second contact holes 28 may be performed in two stages. In this way, because the etch process for forming the contact holes is performed in two stages, an area occupied by the coupling region R2 may be reduced, and thus mass productivity may be increased.

For example, when a 100-step tier is formed, a mold stack according to embodiments of the present disclosure may be formed by dividing the 100-step tier into 50-step tiers. Accordingly, the contact hole etch process may be performed by dividing the 100-step tier into 50-step tiers. In a comparative example, when a contact hole is formed by only one etch process with respect to the 100-step mold stack, a gap between the contact holes may be formed large to avoid interference between the contact holes. When the gap between the contact holes increases, the area occupied by the coupling region has no choice but to increase.

According to various embodiments of the present disclosure, instead of performing a high aspect ratio etch process once on the 100-step mold stack to form contact holes in the coupling region R2 having a stairless structure, the high aspect ratio etch process may be performed twice by dividing the 100-step mold stack into 50-step mold stacks. In this case, as the etch depth for forming the contact holes decreases, the pitch of the contact holes may also decrease. Accordingly, the size of the coupling region R2 may decrease, thereby ensuring net die mass productivity.

According to various embodiments of the present disclosure, the pitch of contact holes may decrease because a multi-step high aspect ratio etch process is performed to form contact holes in a coupling region having a stairless structure. Accordingly, the size of the coupling region may decrease, thereby ensuring net die mass productivity.

While the embodiments of the present disclosure have been illustrated and described with respect to specific embodiments and drawings, the disclosed embodiments are not intended to be restrictive. Further, it is noted that the embodiments may be achieved in various ways through substitution, change, and modification, as those skilled in the art will recognize in light of the present disclosure, without departing from the spirit and/or scope of the present disclosure and the following claims. Furthermore, the embodiments may be combined to form additional embodiments.

## Claims

1. A semiconductor device, comprising:
a first memory cell array including a vertical arrangement of first memory cells;
a second memory cell array vertically disposed over the first memory cell array, and including a vertical arrangement of second memory cells; and
a dummy memory cell array vertically disposed between the first memory cell array and the second memory cell array, and including a vertical arrangement of dummy memory cells.

2. The semiconductor device of claim 1,
wherein the first memory cells, the second memory cells, and the dummy memory cells have the same structure.

3. The semiconductor device of claim 1, further comprising:
a first pad stack including a vertical arrangement of first pads electrically coupled to the first memory cells;
a second pad stack vertically disposed over the first pad stack, and including a vertical arrangement of second pads electrically coupled to the second memory cells; and
a dummy pad stack vertically disposed between the first pad stack and the second pad stack, and including a vertical arrangement of dummy pads.

4. The semiconductor device of claim 3,
wherein the dummy pad stack includes:
a first dummy pad including a non-flat upper surface and a flat lower surface;
a second dummy pad including a non-flat lower surface and a flat upper surface; and
an inter-pad dielectric layer disposed between the first dummy pad and the second dummy pad.

5. The semiconductor device of claim 4,
wherein the non-flat upper surface of the first dummy pad and the non-flat lower surface of the second dummy pad are disposed to face each other with the inter-pad dielectric layer therebetween.

6. The semiconductor device of claim 4,
wherein the non-flat upper surface of the first dummy pad includes a curved profile or an angled profile.

7. The semiconductor device of claim 4,
wherein the non-flat upper surface of the first dummy pad includes a convex profile,
wherein the non-flat lower surface of the second dummy pad includes a concave profile,
wherein the convex profile and the concave profile are disposed to face each other.

8. A semiconductor device, comprising:
a first pad stack including a vertical arrangement of first pads;
a second pad stack vertically disposed over the first pad stack, and including a vertical arrangement of second pads;
a dummy pad stack vertically disposed between the first pad stack and the second pad stack, and including a vertical arrangement of dummy pads; and
a plurality of contact plugs penetrating the second pad stack, the dummy pad stack, and the first pad stack.

9. The semiconductor device of claim 8, wherein the dummy pad stack comprises:
a first dummy pad including a non-flat upper surface;
a second dummy pad vertically disposed over the first dummy pad, and including a non-flat lower surface; and
an inter-pad dielectric layer disposed between the non-flat upper surface of the first dummy pad and the
non-flat lower surface of the second dummy pad.

10. The semiconductor device of claim 9,
wherein the first dummy pad includes the non-flat upper surface having a slope toward a sidewall of the contact plug,
wherein the second dummy pad includes the non-flat lower surface having a slope toward the sidewall of the contact plug, and
wherein the non-flat upper surface and the non-flat lower surface are disposed to face each other with the inter-pad dielectric layer therebetween.

11. A method for fabricating a semiconductor device, the method comprising:
forming a first vertical stack in which first pad sheets are vertically stacked over a substrate;
etching the first pad sheets of the first vertical stack and forming first contact holes;
forming first sacrificial plugs that fill the first contact holes;
forming a dummy stack including dummy pad sheets on the first sacrificial plugs and the first vertical stack;
forming a second vertical stack in which second pad sheets are vertically stacked on the dummy stack;
etching the second pad sheets of the second vertical stack and forming second contact holes;
forming second sacrificial plugs that fill the second contact holes;
removing the second pad sheets and the first pad sheets and forming pad-shaped recesses;
forming pads that fill the pad-shaped recesses; and
replacing the first and second sacrificial plugs with contact plugs.

12. The method of claim 11, wherein the replacing of the first and second sacrificial plugs with the contact plugs includes:
removing the first and second sacrificial plugs and forming contact holes;
forming contact spacers on sidewalls of the contact holes; and
filling the contact holes with a conductive material.

13. The method of claim 11, further comprising:
forming first inter-pad dielectric layers in vertical gaps between the first pad sheets; and
forming second inter-pad dielectric layers in vertical gaps between the second pad sheets.

14. The method of claim 11, wherein the first pad sheets, the dummy pad sheets and the second pad sheets are formed by epitaxial growth.

15. The method of claim 11, wherein the dummy pad sheets are formed on an uppermost first pad sheet of the first vertical stack.
